(19) Europäisches Patentamt
European Patent Office
Office européen des brevets

(11) EP 4 393 925 A1

(12) EUROPEAN PATENT APPLICATION

(43) Date of publication:
**03.07.2024 Bulletin 2024/27**

(21) Application number: **23180869.2**

(22) Date of filing: **22.06.2023**

(51) International Patent Classification (IPC):
***C07F 7/22*** $^{(2006.01)}$ ***G03F 7/00*** $^{(2006.01)}$

(52) Cooperative Patent Classification (CPC):
**C07F 7/2224; G03F 7/00**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **27.12.2022 KR 20220186393**

(71) Applicant: **Samsung Electronics Co., Ltd.**
**Suwon-si, Gyeonggi-do 16677 (KR)**

(72) Inventors:
- **HAN, Sunghyun**
  **16678 Suwon-si (KR)**
- **KOH, Haengdeog**
  **16678 Suwon-si (KR)**
- **KWAK, Yoonhyun**
  **16678 Suwon-si (KR)**
- **KIM, Kyungoh**
  **16678 Suwon-si (KR)**
- **KIM, Mijeong**
  **16678 Suwon-si (KR)**
- **LEE, Jaejun**
  **16678 Suwon-si (KR)**
- **LEE, Hasup**
  **16678 Suwon-si (KR)**
- **IM, Kyuhyun**
  **16678 Suwon-si (KR)**
- **HONG, Sukkoo**
  **16678 Suwon-si (KR)**

(74) Representative: **Elkington and Fife LLP**
**Prospect House**
**8 Pembroke Road**
**Sevenoaks, Kent TN13 1XR (GB)**

# (54) ORGANOMETALLIC COMPOUND, RESIST COMPOSITION INCLUDING THE SAME AND PATTERN FORMING METHOD USING THE SAME

(57) Provided are an organometallic compound represented by one of Formulas 1-1 to 1-4 below,

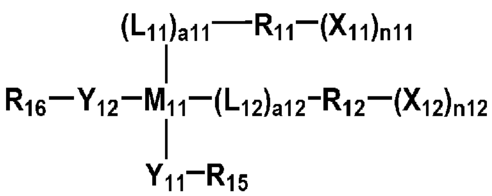

**1-1**

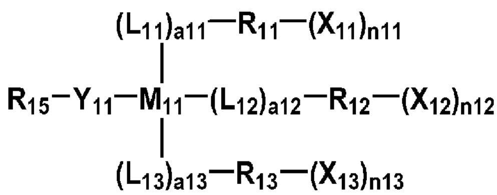

**1-2**

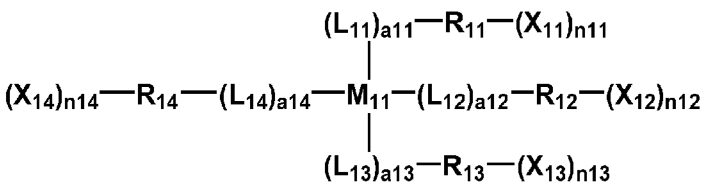

**1-3**

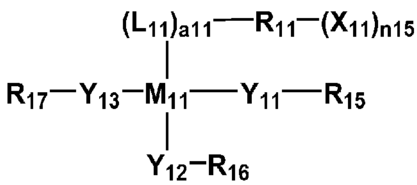

**1-4**

,

a resist composition including the same, and a pattern forming method using the same. For descriptions of $M_{11}$, $L_{11}$ to $L_{14}$, a11 to a14, $R_{11}$ to $R_{14}$, $X_{11}$ to $X_{14}$, n11 to n15, $Y_{11}$ to $Y_{13}$, and $R_{15}$ to $R_{17}$ in Formulas 1-1 to 1-4, refer to the specification.

EP 4 393 925 A1

FIG. 1

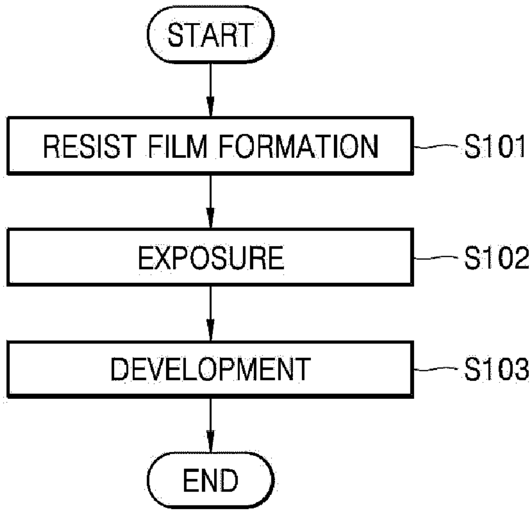
START
RESIST FILM FORMATION
S101
EXPOSURE
S102
DEVELOPMENT
S103
END

## Description

### FIELD OF THE INVENTION

Embodiments are related to an organometallic compound, a resist composition including the same, and a pattern forming method using the same.

### BACKGROUND OF THE INVENTION

To form fine patterns when manufacturing semiconductors, resists of which physical properties change in response to light may be used. Among them, chemically amplified resists have been widely used. In a chemically amplified resist, an acid formed by a reaction between light and a photoacid generator reacts again with a base resin, to change the solubility of the base resin to a developing solution, thereby enabling patterning.

However, when using a chemically amplified resist, the formed acid may diffuse up to an unexposed area, thereby causing a decrease in uniformity of patterns, an increase in surface roughness, etc. In addition, as a semiconductor process scale becomes finer and finer, diffusion control of acids may not be easy, and thus the development of a new type of resist may be required.

Recently, in order to overcome the limitations of chemically amplified resists, attempts have been made to develop materials of which physical properties are changed by exposure. However, there is still a limitation in that a dose required for exposure is high.

### SUMMARY OF THE INVENTION

Accordingly, an embodiment provides an organometallic compound of which physical properties change even by low-dose radiation exposure, and which provides a pattern having improved resolution, a resist composition and a pattern forming method using the same.

Additional aspects will be set forth in part in the description which follows and, in part, will be apparent from the description, or may be learned by practice of the presented embodiments of the disclosure.

According to an aspect, an organometallic compound represented by any one of Formulas 1-1 to 1-4 below:

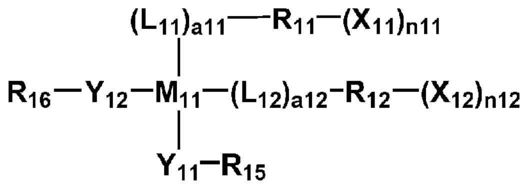

1-1

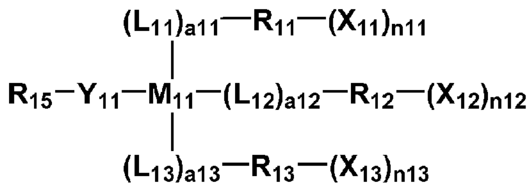

1-2

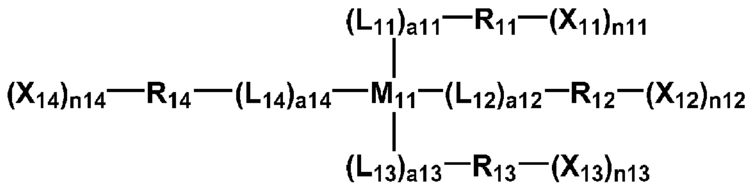

1-3

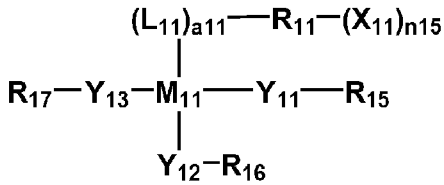

1-4

In Formulas 1-1 to 1-4,

$M_{11}$ may be indium (In), tin (Sn), antimony (Sb), tellurium (Te), thallium (Tl), lead (Pb), bismuth (Bi), or polonium (Po),
$L_{11}$ to $L_{14}$ each independently may be a single bond, or a linear, branched, or cyclic $C_1$-$C_{30}$ divalent hydrocarbon group,
a11 to a14 each independently may be an integer of 1 to 4,
$R_{11}$ and $R_{14}$ each independently may be a substituted or unsubstituted $C_3$-$C_{30}$ cycloalkyl group, a substituted or unsubstituted $C_3$-$C_{30}$ heterocycloalkyl group, a substituted or unsubstituted $C_2$-$C_{30}$ alkenyl group, a substituted or unsubstituted $C_3$-$C_{30}$ cycloalkenyl group, a substituted or unsubstituted $C_3$-$C_{30}$ heterocycloalkenyl group, a substituted or unsubstituted $C_2$-$C_{30}$ alkynyl group, a substituted or unsubstituted $C_6$-$C_{30}$ aryl group, or a substituted or

unsubstituted $C_1$-$C_{30}$ heteroaryl group,
$X_{11}$ to $X_{14}$ each independently may be a halogen, a hydroxyl group, a cyano group, a nitro group, a carboxylic acid group, a linear, branched, or cyclic monovalent $C_1$-$C_{30}$ hydrocarbon group optionally containing a heteroatom, or -$N(Q_1)(Q_2)$,
n11 to n14 each independently may be an integer of 0 to 10,
n15 may be an integer of 1 to 10,
in Formula 1-1, the sum of n11 and n12 is 1 or more,
in Formula 1-2, the sum of n11, n12 and n13 is 1 or more,
in Formula 1-3, the sum of n11, n12, n13 and n14 is 1 or more,
$Y_{11}$ to $Y_{13}$ each independently may be O, S or $NR_{18}$,
$R_{15}$ to $R_{18}$, $Q_1$ and $Q_2$ each independently may be hydrogen, deuterium, or a linear, branched, or cyclic monovalent $C_1$-$C_{30}$ hydrocarbon group optionally containing a heteroatom.

According to an embodiment, a resist composition including the above-described organometallic compound may be provided.
According to an embodiment, a pattern forming method may include applying the resist composition to form a resist film on a substrate; exposing at least a portion of the resist film with high energy rays; and developing the exposed resist film by using a developing solution.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a flowchart showing a pattern forming method according to an embodiment.
FIGS. 2A to 2C are side-sectional views showing a pattern forming method according to an embodiment.
FIGS. 3A to 3C are each a view showing $^1$H-NMR data of Synthesis Examples 1 to 3.
FIGS. 4A to 4E are each a view showing a change in film thickness after development according to doses of Comparative Examples 1 and 2 and Examples 1 to 3.
FIGS. 5A to 5E are side cross-sectional views illustrating a method of forming a patterned structure according to an embodiment.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC.
When the terms "about" or "substantially" are used in this specification in connection with a numerical value, it is intended that the associated numerical value includes a manufacturing or operational tolerance (e.g., $\pm$10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., $\pm$10%) around the stated numerical values or shapes. When ranges are specified, the range includes all values therebetween such as increments of 0.1%.
The disclosure may have various modifications and may be embodied in different forms, and particular embodiments will be explained in detail with reference to the accompanying drawings. It should be understood, however, that it is not intended to limit the disclosure to the particular forms disclosed, but rather, is intended to include all modifications, equivalents, and alternatives falling within the scope of the claims. In describing the disclosure, detailed descriptions of related art may be omitted when it is determined that such detailed descriptions would obscure the gist of the disclosure.
Although the terms "first," "second," "third", and the like may be used herein to describe various elements,

these terms are only used to distinguish one element from another element. The order, type and the like of the elements should not be limited by these terms.

In the description, when a layer, a film, a region, a plate, etc., is referred to as being "on" or "above" another part, it can be not only directly on, below, left, or right in contact, but also include being above, under, left, or right without contact.

The singular forms include the plural forms as well unless the context clearly indicates otherwise. It will be understood that the term "includes" or "comprises", when used in this specification, unless specifically noted to the contrary, specifies the presence of stated features, integers, steps, operations, elements, parts, components, materials, or a combination thereof, but does not preclude the presence or addition of one or more other features, integers, steps, operations, elements, parts, components, materials, or combinations thereof.

Whenever a range of values is enumerated, the range includes all values that fall within the range, as explicitly written, and additionally includes the boundaries of the range. Accordingly, the range "X to Y" includes all values between X and Y, and also includes X and Y.

As used herein, the term "$C_x$-$C_y$" means that a number of carbon atoms forming a substituent is x to y. For example, "$C_1$-$C_6$" means that a number of carbon atoms forming a substituent is 1 to 6, and "$C_6$-$C_{20}$" means that a number of carbon atoms forming a substituent is 6 to 20.

As used herein, a "monovalent hydrocarbon group" may mean a monovalent residue derived from an organic compound including carbon and hydrogen or a derivative thereof. Specific examples thereof may include a linear, or branched alkyl group (for example, a methyl group, an ethyl group, a prophyl group, an isopropyl group, a butyl group, a sec-butyl group, a tert-butyl group, a pentyl group, a neopentyl group, a hexyl group, a heptyl group, a 2-ethylhexyl group, and a nonyl group); a monovalent saturated cyclic aliphatic hydrocarbon group (a cycloalkyl group)(for example, a cyclopentyl group, a cyclohexyl group, a cyclopentylmethyl group, a cyclopentylethyl group, a cyclopentylbutyl group, a cyclohexylmethyl group, a cyclohexylethyl group, a cyclohexylbutyl group, a 1-adamantyl group, a 2-adamantyl group, a 1-adamantylmethyl group, a norbornyl group, a norbornylmethyl group, a tricyclodecanyl group, a tetracyclodecanyl group, a tetracyclodecanylmethyl group, and a dicyclohexylmethyl group); a monovalent unsaturated aliphatic hydrocarbon (an alkenyl group, an alkynyl group) (for example, an allyl group); a monovalent unsaturated cyclic aliphatic hydrocarbon group (a cycloalkenyl group) (for example, a 3-cyclohexenyl group); an aryl group (for example, a phenyl group, a 1-naphthyl group, and a 2-naphthyl group); an arylalkyl group (for example, a benzyl group and a diphenylmethyl group); a monovalent hydrocarbon group containing a heteroatom (for example, a tetrahydrofuranyl group, a methoxymethyl group, an ethoxymethyl group, a methylthiomethyl group, a methylacetamid group, a trifluoroethyl group, a (2-methoxyethoxy)methyl group, an acetoxymethyl group, a 2-carboxy-1-cyclohexyl group, a 2-oxopropyl group, a 4-oxo-1-adamantyl group, and a 3-oxocyclohexyl group), or any combination thereof, etc. In addition, in these groups, since some hydrogens may be substituted with a moiety containing a heteroatom, for example an oxygen atom, a sulfur atom, a nitrogen atom, or a halogen atom, or some carbons may be substituted with a moiety containing a heteroatom, for example, oxygen, sulfur, or nitrogen. Therefore, these groups may contain a hydroxy group, a cyano group, a carbonyl group, a carboxyl group, an ether bond, an ester bond, a sulfonate ester bond, a carbonate, a lactone ring, a sultone ring, a carboxylic anhydride moiety, or a haloalkyl moiety.

As used herein, a "divalent hydrocarbon group" may be a divalent residue, and may mean that one of hydrogens of the monovalent hydrocarbon group has been replaced by a bonding site to a neighboring atom. The divalent hydrocarbon may include, for example, a linear or branched alkylene group, a cycloalkylene group, an akenylene group, an alkynylene group, a cycloalkylene group, an arylene group, or any group in which some carbons thereof are substituted by a heteroatom.

As used herein, an "alkyl group" means a linear or branched monovalent saturated aliphatic hydrocarbon group, and specific examples of the alkyl group include a methyl group, an ethyl group, a propyl group, an isobutyl group, a sec-butyl group, a tert-butyl group, a pentyl group, an iso-amyl group, a hexyl group, etc. As used herein, an "alkylene group" means a linear, or branched divalent saturated aliphatic hydrocarbon group, and specific examples include a methylene group, an ethylene group, a propylene group, a butylene group, an isobutylene group, etc.

As used herein, a "halogenated alkyl group" means a group in which at least one of substituents of the alkyl group is substituted with a halogen atom, and specific examples thereof include $CF_3$, etc. As used herein, halogen is F, Cl, Br, or I.

As used herein, an "alkoxy group" means a monovalent group having Formula of $-OA_{101}$, wherein $A_{101}$ is the alkyl group. Specific examples of the alkoxy group include a methoxy group, an ethoxy group, an isopropyl oxide group, etc.

As used herein, an "alkylthio group" means a monovalent group having Formula of $-SA_{101}$, wherein $A_{101}$ is the alkyl group.

As used herein, a "halogenated alkoxy group" means a group in which at least one of hydrogens of the alkoxy group is substituted with a halogen atom, and specific examples include $-OCF_3$.

As used herein, a "halogenated alkylthio group" means a group in which at least one hydrogen of an alkylthio

group is substituted with a halogen atom, and specific examples include $-SCF_3$.

As used herein, a "cycloalkyl group" means a cyclic saturated monovalent hydrocarbon group, and specific examples thereof include monocyclic groups such as a cyclopropyl group, a cyclobutyl group, a cyclopentyl group, a cyclohexyl group, and a cycloheptyl group, and a fused polycyclic groups such as a norbornyl group and an adamantyl group. As used herein, a "cycloalkylene group" means a cyclic divalent saturated hydrocarbon group, and specific examples include a cyclopentylene group, a cyclohexylene group, an adamantylene group, an adamantylmethylene group, a norbornylene group, a norbornylmethylene group, a tricyclodecanylene group, a tetracyclododecanylene group, a tetracyclododecanylmethylene group, a dicyclohexylmethylene group, etc.

As used herein, a "cycloalkoxy group" means a monovalent group having Formula of $-OA_{102}$, wherein $A_{102}$ is the cycloalkyl group. Specific examples include a cyclopropoxy group, a cyclobutoxy group, etc.

As used herein, a "cycloalkylthio group" means a monovalent group having Formula of $-SA_{102}$, wherein $A_{102}$ is the cycloalkyl group.

As used herein, in a "heterocycloalkyl group", some carbon atoms of the cycloalkyl group may be substituted by a heteroatom containing, for example, oxygen, sulfur, or nitrogen, and the heterocycloalkyl group; and may contain an ether bond, an ester bond, a sulfonate ester bond, a carbonate, a lactone ring, a sultone ring, or a carboxylic anhydride moiety. As used herein, in a "heterocycloalkylene group", some carbon atoms of the cycloalkylene group are substituted by a moiety containing heteroatom, for example, oxygen, sulfur, or nitrogen.

As used herein, a "heterocycloalkoxy group" means a monovalent group having Formula of $-OA_{103}$, wherein $A_{103}$ is the heterocycloalkyl group.

As used herein, an "alkenyl group" means a linear, or branched unsaturated aliphatic monovalent hydrocarbon group containing at least one carbon-carbon double bond. As used herein, an "alkenylene group" means a linear, branched unsaturated aliphatic divalent hydrocarbon group containing at least one carbon-carbon double bond.

As used herein, a "cycloalkynyl group" means a cyclic monovalent unsaturated hydrocarbon group containing at least one carbon-carbon double bond. As used herein, a "cycloalkenylene group" means a cyclic unsaturated divalent hydrocarbon group containing at least one carbon-carbon double bond.

As used herein, in a "heterocycloalkenyl group", some carbon atoms of the cycloalkenylene group are substituted by a moiety containing a heteroatom, for example, oxygen, sulfur, or nitrogen. As used herein, in a "heterocycloalkenylene group", some carbon atoms of the cycloalkenylene group are substituted by a moiety containing a heteroatom, for example, oxygen, sulfur, or nitrogen.

As used herein, an "alkynyl group" means an unsaturated aliphatic monovalent hydrocarbon group containing at least one of carbon-carbon triple bond.

As used herein, an "aryl group" means a monovalent group having a carbocyclic aromatic system, and specific examples thereof include a phenyl group, a naphthyl group, an anthracenyl group, a phenanthrenyl group, a pyrenyl group, a chrysenyl group, etc. As used herein, an "arylene group" means a divalent group having a carbocyclic aromatic system.

As used herein, a "heteroaryl group" means a monovalent group having a heterocyclic aromatic system, and specific examples of the heteroaryl group include a pyridinyl group, a pyrimidinyl group, a pyrazinyl group, etc. As used herein, a "heteroarylene group" means a divalent group having a heterocyclic aromatic system.

As used herein, a "substituent" includes: deuterium, halogen, a hydroxyl group, a cyano group, a nitro group, a carbonyl group, a carboxylic acid group, an amino group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group, a $C_6$-$C_{20}$ aryloxy group, a $C_6$-$C_{20}$ arylthio group , a $C_1$-$C_{20}$ heteroaryl group, a $C_1$-$C_{20}$ heteroaryloxy group, or a $C_1$-$C_{20}$ heteroarylthio group;

a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group, a $C_6$-$C_{20}$ aryloxy group, a $C_6$-$C_{20}$ arylthio group , a $C_1$-$C_{20}$ heteroaryl group, a $C_1$-$C_{20}$ heteroaryloxy group, or a $C_1$-$C_{20}$ heteroarylthio group each being substituted with deuterium, halogen, a hydroxyl group, a cyano group, a nitro group, a carbonyl group, a carboxylic acid group, an amino group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group, a $C_6$-$C_{20}$ aryloxy group, a $C_6$-$C_{20}$ arylthio group, a $C_1$-$C_{20}$ heteroaryl group, a $C_1$-$C_{20}$ heteroaryloxy group, or a $C_1$-$C_{20}$ heteroarylthio group and any combination thereof; and any combination thereof.

Hereinafter, embodiments will be described with reference to the accompanying drawings. In describing with reference to the drawings, the same reference numerals are used for substantially identical or corresponding elements,

and duplicate descriptions are omitted herein. In the drawings, the thickness is enlarged to show the different layers and regions clearly. In addition, in the drawings, the thickness of some layers and regions may be exaggerated for illustrative purposes. It should be understood that the embodiments described below are only illustrations, and various modifications from these embodiments are possible.

**[Organometallic compound]**

An organometallic compound according to embodiments is represented by any one of Formulas 1-1 to 1-4 below:

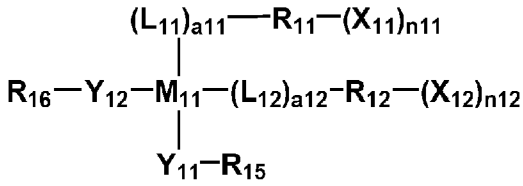

1-1

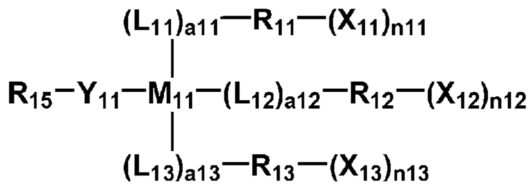

1-2

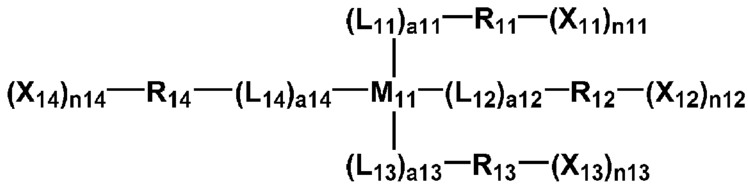

1-3

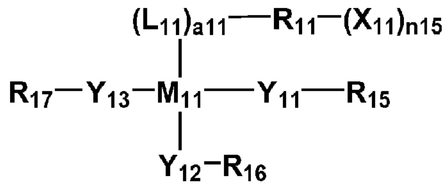

1-4

In Formulas 1-1 to 1-4,

$M_{11}$ may be indium (In), tin (Sn), antimony (Sb), tellurium (Te), thallium (Tl), lead (Pb), bismuth (Bi), or polonium (Po),
$L_{11}$ to $L_{14}$ each independently may be a single bond, or a linear, branched, or cyclic $C_1$-$C_{30}$ divalent hydrocarbon group,
a11 to a14 each independently may be an integer of 1 to 4,
$R_{11}$ and $R_{14}$ each independently may be a substituted or unsubstituted $C_3$-$C_{30}$ cycloalkyl group, a substituted or unsubstituted $C_3$-$C_{30}$ heterocycloalkyl group, a substituted or unsubstituted $C_2$-$C_{30}$ alkenyl group, a substituted or unsubstituted $C_3$-$C_{30}$ cycloalkenyl group, a substituted or unsubstituted $C_3$-$C_{30}$ heterocycloalkenyl group, a substituted or unsubstituted $C_2$-$C_{30}$ alkynyl group, a substituted or unsubstituted $C_6$-$C_{30}$ aryl group, or a substituted or unsubstituted $C_1$-$C_{30}$ heteroaryl group,
$X_{11}$ to $X_{14}$ each independently may be a halogen, a hydroxyl group, a cyano group, a nitro group, a carboxylic acid group, or a linear, branched, or cyclic monovalent $C_1$-$C_{30}$ hydrocarbon group optionally containing a heteroatom, or $-N(Q_1)(Q_2)$,
n11 to n14 each independently may be an integer of 0 to 10,
n15 may be an integer of 1 to 10,
in Formula 1-1, the sum of n11 and n12 is 1 or more,
in Formula 1-2, the sum of n11, n12 and n13 is 1 or more,
in Formula 1-3, the sum of n11, n12, n13 and n14 is 1 or more,
$Y_{11}$ to $Y_{13}$ each independently may be O, S or $NR_{18}$,
$R_{15}$ to $R_{18}$, $Q_1$ and $Q_2$ each independently may be hydrogen, deuterium, or a linear, branched, or cyclic monovalent $C_1$-$C_{30}$ hydrocarbon group optionally containing a heteroatom.

The organometallic compound may have a molecular weight of 3000 g/mol or less. In some embodiments, the organometallic compound may have a molecular weight of 2000 g/mol or less.
For example, in Formulas 1-1 to 1-4, $M_{11}$ may be In, Sn, or Sb. In some embodiments, in Formulas 1-1 to 1-4, $M_{11}$ may be Sn.
For example, in Formulas 1-1 to 1-4, $L_{11}$ to $L_{14}$ are each independently, a single bond, a substituted or unsubstituted $C_1$-$C_{30}$ alkylene group, a substituted or unsubstituted $C_3$-$C_{30}$ cycloalkylene group, a substituted or unsubstituted $C_3$-$C_{30}$ heterocycloalkylene group, a substituted or unsubstituted $C_2$-$C_{30}$ alkenylene group, a substituted or unsubstituted $C_3$-$C_{30}$ cycloalkenylene group, a substituted or unsubstituted $C_3$-$C_{30}$ heterocycloalkenylene group, a substituted or

unsubstituted $C_6$-$C_{30}$ arylene group, or a substituted or unsubstituted $C_1$-$C_{30}$ heteroarylene group.

In some embodiments, in Formulas 1-1 to 1-4, $L_{11}$ to $L_{14}$ may be each independently selected from: a single bond; and a $C_1$-$C_{30}$ alkylene group, a $C_3$-$C_{30}$ cycloalkylene group, a $C_3$-$C_{30}$ heterocycloalkylene group, a $C_2$-$C_{30}$ alkenylene group, a $C_3$-$C_{30}$ cycloalkylene group, a $C_3$-$C_{30}$ heterocycloalkylene group, a $C_2$-$C_{30}$ alkenylene group, a $C_3$-$C_{30}$ cycloalkenylene group, a $C_3$-$C_{30}$ heterocycloalkenylene group, a $C_6$-$C_{30}$ arylene group, and a $C_1$-$C_{30}$ heteroarylene group each being substituted or unsubstituted with deuterium, halogen, a hydroxy group, a cyano group, a nitro group, an amino group, a carbonyl group, a carboxylic acid group, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ of aryl group, or any combination thereof.

In some embodiments, in Formulas 1-1 to 1-4, $L_{11}$ to $L_{14}$ may be each independently selected from a single bond; and a $C_1$-$C_{30}$ alkylene group substituted or unsubstituted with deuterium halogen, a hydroxy group, a cyano group, a $C_1$-$C_{20}$ alkyl group, a $C_1$-$C_{20}$ halogenated alkyl group, or any combination thereof.

In Formulas 1-1 to 1-4, a11 to a14 may mean each number of $L_{11}$ to $L_{14}$ repetitions, and for example, in Formulas 1-1 to 1-4, a11 to a15 may be each independently integers of 1 or 2.

For example, in Formulas 1-1 to 1-4, $R_{11}$ to $R_{14}$ may be each independently selected from a $C_3$-$C_{30}$ cycloalkyl group, a $C_3$-$C_{30}$ heterocycloalkyl group, a $C_2$-$C_{30}$ alkenyl group, a $C_3$-$C_{30}$ cycloalkenyl group, a $C_3$-$C_{30}$ heterocycloalkenyl group, a $C_2$-$C_{30}$ alkynyl group, a $C_6$-$C_{30}$ aryl group, and a $C_1$-$C_{30}$ heteroaryl group each being substituted or unsubstituted with deuterium, halogen, a hydroxyl group, a cyano group, a nitro group, an amino group, a carbonyl group, a carboxylic acid group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group, or any combination thereof.

In some embodiments, in Formulas 1-1 to 1-4, $R_{11}$ to $R_{14}$ may be each independently selected from a $C_3$-$C_{30}$ cycloalkyl group, a $C_3$-$C_{30}$ heterocycloalkyl group, a $C_3$-$C_{30}$ cycloalkenyl group, a $C_3$-$C_{30}$ heterocycloalkenyl group, a $C_6$-$C_{30}$ aryl group, and a $C_1$-$C_{30}$ heteroaryl group each being substituted or unsubstituted with deuterium, halogen, a hydroxyl group, a cyano group, a nitro group, a carbonyl group, a carboxylic acid group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group, or any combination thereof.

In some embodiments, in Formulas 1-1 to 1-4, $R_{11}$ to $R_{14}$ may be each independently selected from a $C_3$-$C_{30}$ cycloalkyl group, a $C_3$-$C_{30}$ heterocycloalkyl group, a $C_3$-$C_{30}$ cycloalkenyl group, a $C_3$-$C_{30}$ heterocycloalkenyl group, a $C_6$-$C_{30}$ aryl group, and a $C_1$-$C_{30}$ heteroaryl group each being substituted or unsubstituted with deuterium, halogen, a hydroxyl group, a cyano group, a nitro group, a carbonyl group, a carboxylic acid group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ halogenated alkoxy group, a $C_3$-$C_{20}$ cycloalkyl group, a $C_3$-$C_{20}$ cycloalkoxy group, a $C_6$-$C_{20}$ aryl group, or any combination thereof.

For example, in Formulas 1-1 to 1-4, $X_{11}$ to $X_{14}$ may be each independently selected from: a halogen; a hydroxyl group; a cyano group; a nitro group; a carboxylic acid group; a $C_1$-$C_{30}$ alkyl group, a $C_1$-$C_{30}$ halogenated alkyl group, a $C_1$-$C_{30}$ alkoxy group, a $C_1$-$C_{30}$ alkylthio group, a $C_1$-$C_{30}$ halogenated alkoxy group, a $C_1$-$C_{30}$ halogenated alkylthio group, a $C_3$-$C_{30}$ cycloalkyl group, a $C_3$-$C_{30}$ cycloalkoxy group and a $C_3$-$C_{30}$ cycloalkylthio group each being substituted or unsubstituted with deuterium, halogen, a hydroxyl group, a cyano group, a nitro group, an amino group, a carbonyl group, a carboxylic acid group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group or any combination thereof; and $-N(Q_1)(Q_2)$,

$Q_1$ and $Q_2$ may be each independently selected from: hydrogen; deuterium; and a $C_1$-$C_{30}$ alkyl group, a $C_3$-$C_{30}$ cycloalkyl group, a $C_3$-$C_{30}$ cycloalkenyl group, and a $C_6$-$C_{30}$ aryl group, each being substituted or unsubstituted with deuterium, halogen, a hydroxyl group, a cyano group, a nitro group, a carbonyl group, a carboxylic acid group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group, or any combination thereof.

In some embodiments, in Formulas 1-1 to 1-4, $X_{11}$ to $X_{14}$ may be each independently selected from: halogen;

a hydroxyl group; a carboxylic acid group; a $C_1$-$C_{30}$ alkyl group, a $C_1$-$C_{30}$ halogenated alkyl group, a $C_1$-$C_3$ alkoxy group, and a $C_1$-$C_{30}$ halogenated alkoxy group each being substituted or unsubstituted with deuterium, halogen, a hydroxyl group, an amino group, a carbonyl group, a carboxylic acid group, an ether moiety, an ester moiety, a sulfonate ester moiety, a carbonate moiety, an amide moiety, a $C_1$-$C_{20}$ alkyl group, a $C_1$-$C_{20}$ halogenated alkyl group, a $C_3$-$C_{20}$ cycloalkyl group, a $C_6$-$C_{20}$ aryl group, or any combination thereof; and -N($Q_1$)($Q_2$),

$Q_1$ and $Q_2$ may be each independently selected from: hydrogen; deuterium; and a $C_1$-$C_{30}$ alkyl group, and a $C_6$-$C_{30}$ aryl group each being substituted or unsubstituted with deuterium, halogen, a hydroxyl group, an amino group, a carbonyl group, a carboxylic acid group, an ether moiety, an ester moiety, a sulfonate ester moiety, a carbonate moiety, an amide moiety, a $C_1$-$C_{20}$ alkyl group, a $C_1$-$C_{20}$ halogenated alkyl group, a $C_3$-$C_{20}$ cycloalkyl group, a $C_6$-$C_{20}$ aryl group, or any combination thereof.

In some embodiments, in Formulas 1-1 to 1-4, $X_{11}$ to $X_{14}$ may be each independently selected from: halogen; a hydroxyl group; a carboxylic acid group; and a $C_1$-$C_{30}$ alkyl group, a $C_1$-$C_{30}$ alkoxy group, each being substituted or unsubstituted with deuterium, halogen, a hydroxyl group, a carbonyl group, a carboxylic acid group, an ether moiety, an ester moiety, a carbonate moiety, an amide moiety, an amide moiety, a $C_1$-$C_{20}$ alkyl group, a $C_1$-$C_{20}$ halogenated alkyl group, or any combination thereof.

Particularly, in Formulas 1-1 to 1-4, $X_{11}$ to $X_{14}$ may be each independently selected from: halogen, a hydroxyl group; and a $C_1$-$C_{30}$ alkyl group and a $C_1$-$C_{30}$ alkoxy group, each being substituted or unsubstituted with deuterium, a halogen or any combination thereof.

According to an embodiment, in Formulas 1-1 to 1-4, *-$R_{11}$-$(X_{11})_{n11}$ may be represented by any one of Formulas 2-1 to 2-18, *-$R_{12}$-$(X_{12})_{n12}$ may be represented by any one of Formulas 2-21 to 2-38, *-$R_{13}$-$(X_{13})_{n13}$ may be represented by any one of Formulas 2-41 to 2-58, and *-$R_{14}$-$(X_{14})_{n14}$ may be represented by any one of Formulas 2-61 to 2-78:

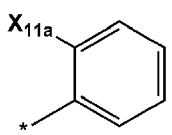
2-1

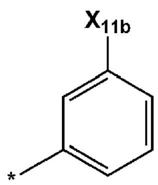
2-2

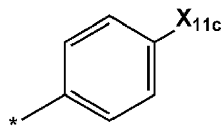
2-3

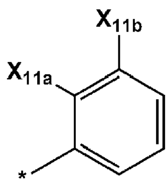
2-4

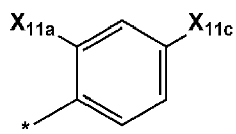
2-5

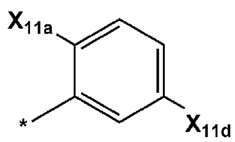
2-6

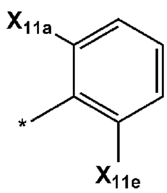
2-7

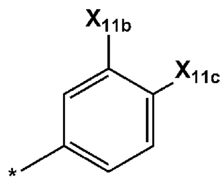
2-8

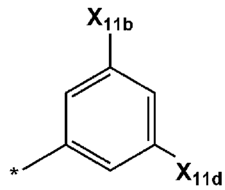
2-9

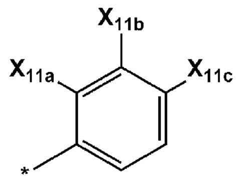
2-10

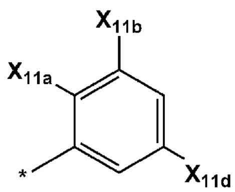
2-11

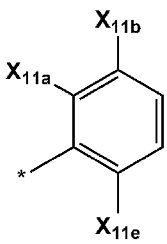
2-12

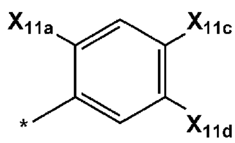
2-13

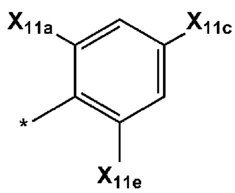
2-14

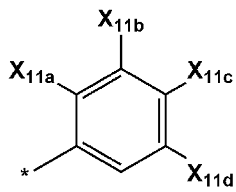
2-15

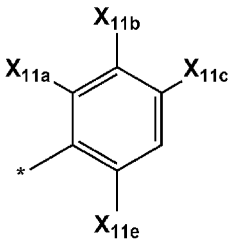
2-16

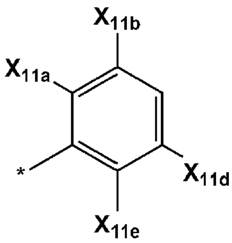
2-17

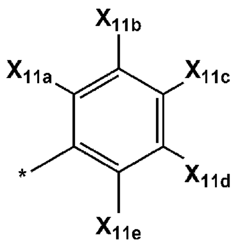
2-18

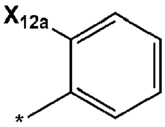
2-21

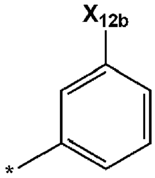
2-22

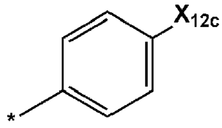
2-23

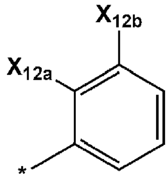
2-24

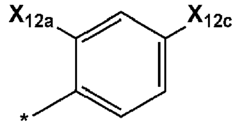
2-25

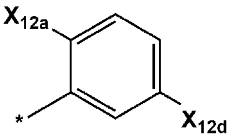
2-26

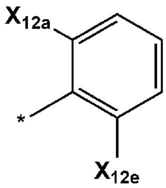
2-27

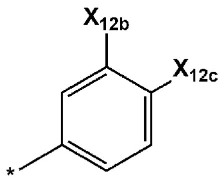
2-28

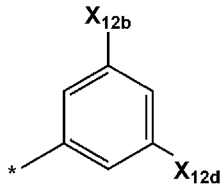
2-29

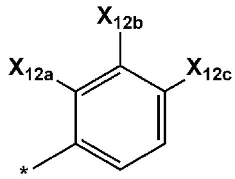
2-30

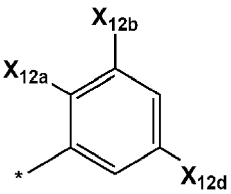
2-31

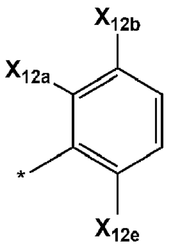
2-32

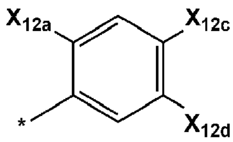
2-33

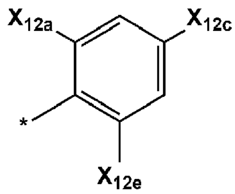
2-34

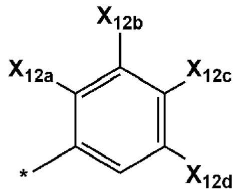
2-35

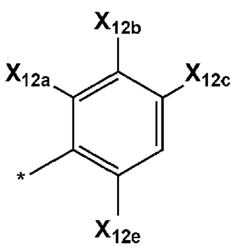
2-36

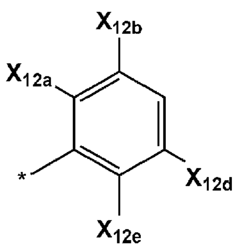
2-37

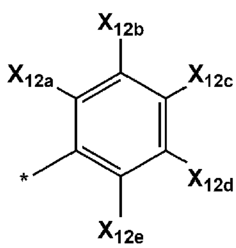
2-38

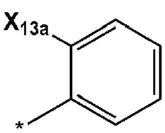
2-41

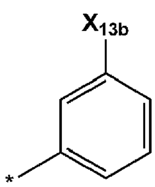
2-42

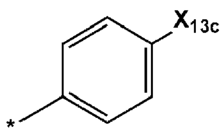
2-43

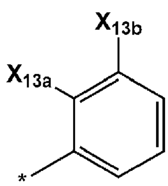
2-44

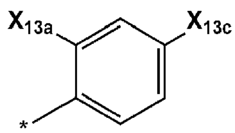
2-45

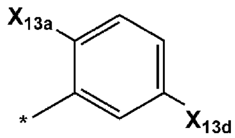
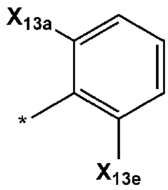
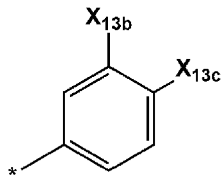
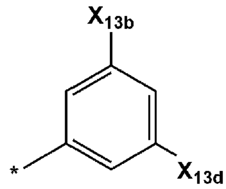
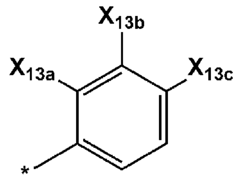

2-46 2-47 2-48 2-49 2-50

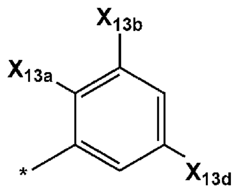
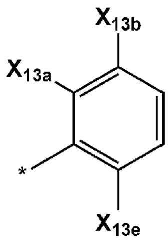
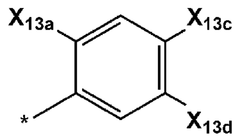
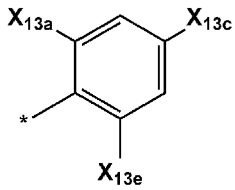
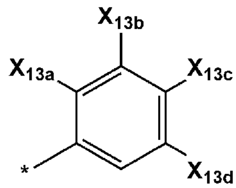

2-51 2-52 2-53 2-54 2-55

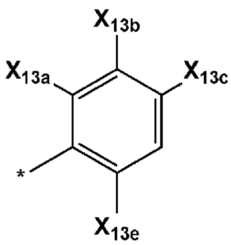
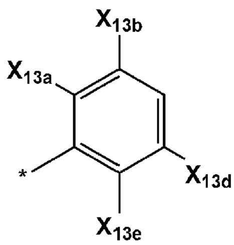
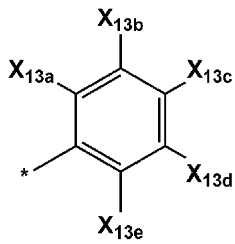

2-56 2-57 2-58

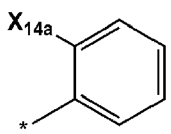
2-61
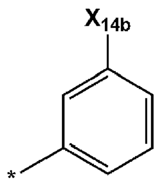
2-62
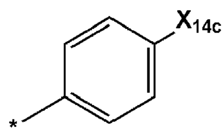
2-63
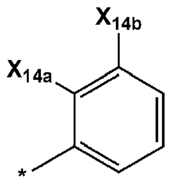
2-64
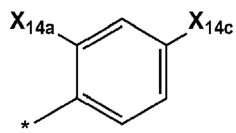
2-65

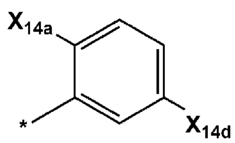
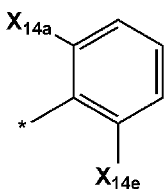
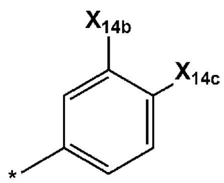
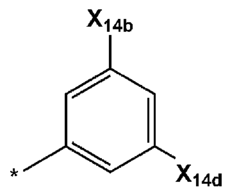
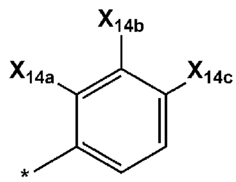

2-66 2-67 2-68 2-69 2-70

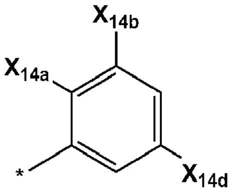

2-71

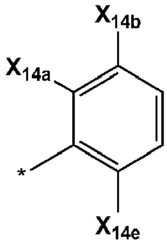

2-72

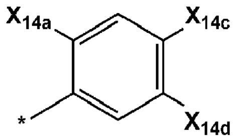

2-73

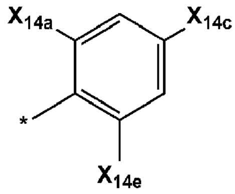

2-74

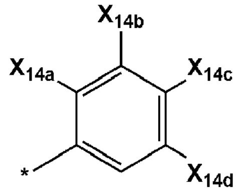

2-75

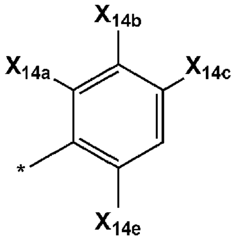

2-76

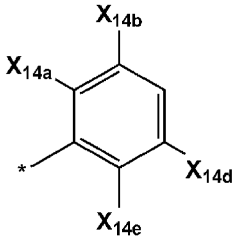

2-77

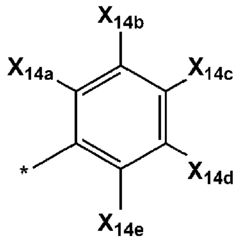

2-78

In Formulas 2-1 to 2-18, 2-21 to 2-38, 2-41 to 2-58, and 2-61 to 2-78,

$X_{11a}$ to $X_{11e}$, $X_{12a}$ to $X_{12e}$, $X_{13a}$ to $X_{13e}$, and $X_{14a}$ to $X_{14e}$ are each independently a halogen, a hydroxyl group, a cyano group, a nitro group, a carboxylic acid group, a linear, branched, or cyclic $C_1$-$C_{30}$ monovalent hydrocarbon group optionally containing a heteroatom, or -N($Q_1$)($Q_2$), and

$Q_1$ and $Q_2$ are each independently, hydrogen, deuterium, or a linear, branched, or cyclic monovalent $C_1$-$C_{30}$ hydrocarbon group optionally containing a heteroatom.

In Formulas 2-1 to 2-18, 2-21 to 2-38, 2-41 to 2-58, and 2-61 to 2-78, descriptions for $X_{11a}$ to $X_{11e}$, $X_{12a}$ to $X_{12e}$, $X_{13a}$ to $X_{13e}$, and $X_{14a}$ to $X_{14e}$ refer to descriptions for $X_{11}$ to $X_{14}$.

In some embodiments, in Formulas 2-1 to 2-18, 2-21 to 2-38, 2-41 to 2-58, and 2-61 to 2-78, $X_{11a}$ to $X_{11e}$, $X_{12a}$ to $X_{12e}$, $X_{13a}$ to $X_{13e}$, and $X_{14a}$ to $X_{14e}$ may be each independently selected from: a halogen; a hydroxyl group; a carboxylic acid group; and a $C_1$-$C_{30}$ alkyl group and a $C_1$-$C_{30}$ alkoxy group each being substituted or unsubstituted with deuterium, halogen, a hydroxyl group, a carbonyl group, a carboxylic acid group, an ether moiety, an ester moiety, a carbonate moiety, an amide moiety, a $C_1$-$C_{20}$ alkyl group, a $C_1$-$C_{20}$ halogenated alkyl group, or any combination thereof.

In some embodiments, in Formulas 2-1 to 2-18, 2-21 to 2-38, 2-41 to 2-58, and 2-61 to 2-78, $X_{11a}$ to $X_{11e}$, $X_{12a}$ to $X_{12e}$, $X_{13a}$ to $X_{13e}$, and $X_{14a}$ to $X_{14e}$ may be each independently selected from: a halogen; a hydroxyl group; and a $C_1$-$C_{30}$ alkyl group and a $C_1$-$C_{30}$ alkoxy group each being substituted or unsubstituted with deuterium, halogen, or any combination thereof.

According to another embodiment, in Formulas 1-1 to 1-4, *-$R_{11}$-$(X_{11})_{n11}$ may be represented by any one of 2-1, 2-3, 2-5, and 2-14, *-$R_{12}$-$(X_{12})_{n12}$ may be represented by any one of 2-21, 2-23, 2-25, and 2-34, *-$R_{13}$-$(X_{13})_{n13}$ may be represented by any one of 2-41, 2-43, 2-45, and 2-54, and *-$R_{14}$-$(X_{14})_{n14}$ may be represented by any one of 2-61, 2-63, 2-65, and 2-74.

According to an embodiment, in Formulas 1-1 to 1-4, *-$R_{11}$-$(X_{11})_{n11}$ may be represented by any one of Formulas 2-2 and 2-9, *-$R_{12}$-$(X_{12})_{n12}$ may be represented by any one of Formulas 2-22 and 2-29, *-$R_{13}$-$(X_{13})_{n13}$ may be represented by any one of Formulas 2-42 and 2-49, and *-$R_{14}$-$(X_{14})_{n14}$ may be represented by any one of Formulas 2-62 and 2-69.

In some embodiments, in Formula 1-1, a sum of n11 and n12 may be 1 or 2. In some embodiments, in Formula 1-1, a sum of n11 and n12 may be 2.

In some embodiments, n Formula 1-2, a sum of n11, n12 and n13 may be 1, 2, or 3. In some embodiments, in Formula 1-2, a sum of n11, n12 and n13 may be 3.

In some embodiments, in Formula 1-3, a sum of n11, n12, n13 and n14 may be 1, 2, 3 or 4. In some embodiments, in Formula 1-3, a sum of n11, n12, n13 and n14 may be 4.

For example, in Formula 1-4, n15 may be 1 or 2. In some embodiments, in Formula 1-4, n15 may be 1.

For example, in Formulas 1-1 to 1-4, $Y_{11}$ to $Y_{13}$ may be each independently O or S. In some embodiments, in Formulas 1-1 to 1-4, $Y_{11}$ to $Y_{13}$ may be O.

For example, in Formulas 1-1 to 1-4, $R_{15}$ to $R_{17}$ may be each independently represented by *-$(L_{15})_{a15}$-$X_{15}$, $L_{15}$

may be $CR_aR_b$, C=O, S=O, $SO_2$, $PO_2$, or $PO_3$, a15 may be an integers of 0 to 3, $X_{15}$ may be a linear, branched, or cyclic monovalent $C_1$-$C_{30}$ hydrocarbon group optionally containing a heteroatom, $R_a$ and $R_b$ may be each independently hydrogen, deuterium, a halogen, a hydroxyl group, a cyano group, a nitro group, a substituted or unsubstituted $C_1$-$C_{30}$ alkyl group, a substituted or unsubstituted $C_1$-$C_{30}$ alkoxy group, a substituted or unsubstituted $C_3$-$C_{30}$ cycloalkyl group, a substituted or unsubstituted $C_3$-$C_{30}$ cycloalkoxy group, a substituted or unsubstituted $C_2$-$C_{30}$ alkenyl group, a substituted or unsubstituted $C_3$-$C_{30}$ cycloalkenyl group, a substituted or unsubstituted $C_2$-$C_{30}$ alkynyl group, a substituted or unsubstituted $C_6$-$C_{30}$ aryl group, or a substituted or unsubstituted $C_7$-$C_{30}$ arylalkyl group, and * may be a bonding site to a neighboring atom.

In some embodiments, in Formulas 1-1 to 1-4, $R_{15}$ to $R_{17}$ may be each independently represented by *-$(L_{15})_{a15}$-$X_{15}$, $L_{15}$ may be $CR_aR_b$, or C=O, a15 may be 0 or 1, $X_{15}$ may be a substituted or unsubstituted $C_1$-$C_{30}$ alkyl group, a substituted or unsubstituted $C_1$-$C_{30}$ alkoxy group, a substituted or unsubstituted $C_3$-$C_{30}$ cycloalkyl group, a substituted or unsubstituted $C_3$-$C_{30}$ cycloalkoxy group" a substituted or unsubstituted $C_2$-$C_{30}$ alkenyl group, a substituted or unsubstituted $C_3$-$C_{30}$ cycloalkenyl group, a substituted or unsubstituted $C_2$-$C_{30}$ alkynyl group, a substituted or unsubstituted $C_6$-$C_{30}$ aryl group, a substituted or unsubstituted $C_7$-$C_{30}$ arylalkyl group, and $R_a$ and $R_b$ may be each independently hydrogen, deuterium, halogen, a hydroxyl group, a cyano group, a nitro group, a substituted or unsubstituted $C_1$-$C_{30}$ alkyl group, a substituted or unsubstituted $C_1$-$C_{30}$ alkoxy group, a substituted or unsubstituted $C_3$-$C_{30}$ cycloalkyl group, and a substituted or unsubstituted $C_3$-$C_{30}$ cycloalkoxy group.

In some embodiments, in Formulas 1-1 to 1-4, $R_{15}$ to $R_{17}$ may be each independently represented by *-$(L_{15})_{a15}$-$X_{15}$, $L_{15}$ may be $CR_aR_b$, or C=O, a15 may be 0 or 1, $X_{15}$ may be selected from a $C_1$-$C_{30}$ alkyl group, a $C_1$-$C_{30}$ alkoxy group, a $C_3$-$C_{30}$ cycloalkyl group, a $C_3$-$C_{30}$ cycloalkoxy group, a $C_2$-$C_{30}$ alkenyl group, a $C_3$-$C_{30}$ cycloalkenyl group, a $C_2$-$C_{30}$ alkynyl group, a $C_6$-$C_{30}$ aryl group, and $C_7$-$C_{30}$ arylalkyl group, each being substituted or unsubstituted with deuterium, halogen, a hydroxyl group, a cyano group, a nitro group, an amino group, a carbonyl group, a carboxylic acid group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ halogenated alkoxy group, a $C_3$-$C_{20}$ cycloalkyl group, a $C_3$-$C_{20}$ cycloalkoxy group, a $C_2$-$C_{20}$ alkenyl group, a $C_6$-$C_{20}$ aryl group, or any combination thereof, and $R_a$ and $R_b$ may be each independently selected from: hydrogen; deuterium; halogen; a hydroxyl group; a cyano group; a nitro group; and a $C_1$-$C_{30}$ alkyl group, a $C_1$-$C_{30}$ alkoxy group, a $C_3$-$C_{30}$ cycloalkyl group, and a $C_3$-$C_{30}$ cycloalkoxy group, each being substituted or unsubstituted with deuterium, halogen, a hydroxyl group, a cyano group, a nitro group, an amino group, a carbonyl group, a carboxylic acid group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ halogenated alkoxy group, a $C_3$-$C_{20}$ cycloalkyl group, a $C_3$-$C_{20}$ cycloalkoxy group, a $C_2$-$C_{20}$ alkenyl group, a $C_6$-$C_{20}$ aryl group, or any combination thereof.

Particularly, in Formulas 1-1 to 1-4, $R_{15}$ to $R_{17}$ may be each independently represented by *-$(L_{15})_{a15}$-$X_{15}$, $L_{15}$ may be C=O, a15 may be 1, and $X_{15}$ may be selected from a $C_1$-$C_{30}$ alkyl group which is substituted or unsubstituted with deuterium, halogen, a hydroxyl group, a cyano group, a nitro group, an amino group, a carbonyl group, a carboxylic acid group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ halogenated alkoxy group, a $C_3$-$C_{20}$ cycloalkyl group, a $C_3$-$C_{20}$ cycloalkoxy group, a $C_2$-$C_{20}$ alkenyl group, a $C_6$-$C_{20}$ aryl group, or any combination thereof.

For example, in Formulas 1-1 to 1-4, $R_{18}$ may be each independently selected from: hydrogen; deuterium; and a $C_1$-$C_{30}$ alkyl group, a $C_3$-$C_{30}$ cycloalkyl group, a $C_3$-$C_{30}$ cycloalkenyl group, and a $C_6$-$C_{30}$ aryl group each being substituted or unsubstituted with deuterium, halogen, a hydroxyl group, a cyano group, a nitro group, an amino group, a carbonyl group, a carboxylic acid group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ halogenated alkoxy group, a $C_3$-$C_{20}$ cycloalkyl group, a $C_3$-$C_{20}$ cycloalkoxy group, a $C_6$-$C_{20}$ aryl group, or any combination thereof.

In some embodiments, in Formulas 1-1 to 1-4, $R_{18}$ may be each independently selected from: hydrogen; deuterium; and a $C_1$-$C_{30}$ alkyl group, and a $C_6$-$C_{30}$ aryl group, each being substituted or unsubstituted with deuterium, halogen, a hydroxyl group, an amino group, a carbonyl group, a carboxylic acid group, an ether moiety, an ester moiety, a sulfonate ester moiety, a carbonate moiety, an amide moiety, a $C_1$-$C_{20}$ alkyl group, a $C_1$-$C_{20}$ halogenated alkyl group, a $C_3$-$C_{20}$ cycloalkyl group, a $C_6$-$C_{20}$ aryl group, or any combination thereof.

According to an embodiment, the organometallic compound represented by any one of Formulas 1-1 to 1-4, may be selected from group I below:

<Group I>

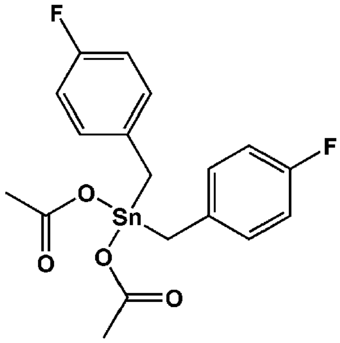
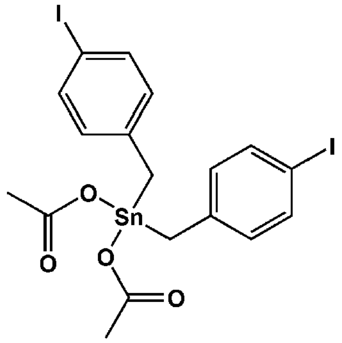
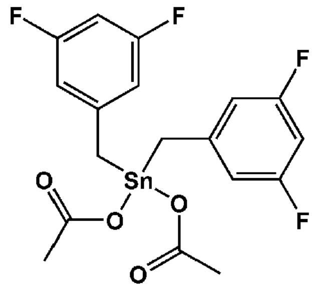
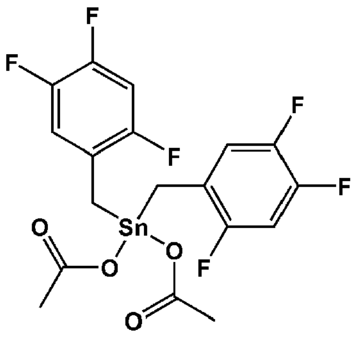
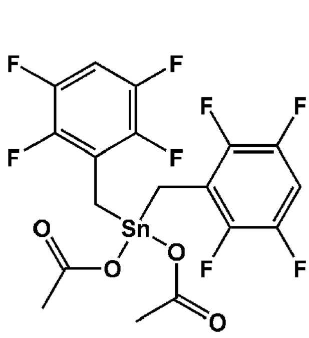
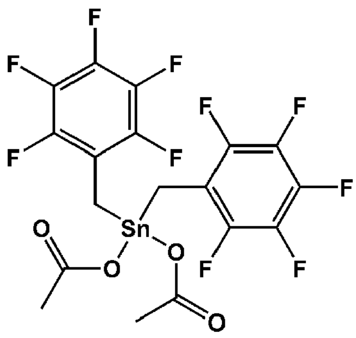
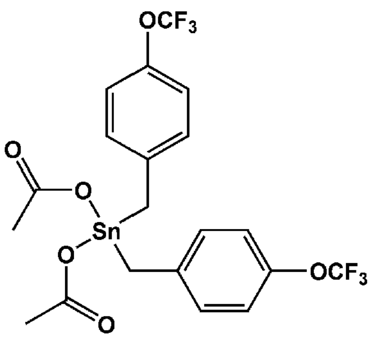
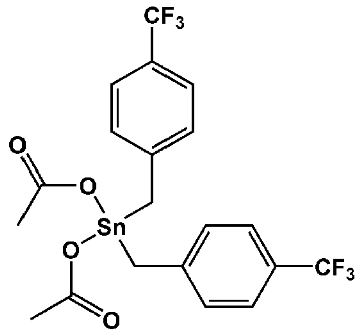

Although not limited to a specific theory, in the organometallic compound, radicals may be formed by heat and/or high-energy rays. In some embodiments, radicals may be formed from $M_{11}$-carbon bond of the organometallic compound, and the radicals may react in an atmosphere in which water optionally exists, thereby forming a chemical bond between the organometallic compounds. Therefore, physical properties of the organometallic compound, particularly the solubility to a developing solution, may change.

Particularly, the organometallic compound represented by any one of Formulas 1-1 to 1-4 necessarily includes at least one substituent, such as $X_{11}$, and thereby having improved resolution and/or photosensitivity to high-energy rays, particularly to EUV. More particularly, when the organometallic compound represented by Formulas 1-1 to 1-4 includes a halogen, for example, fluorine, iodine, etc., the organometallic compound having particularly improved absorbance may be provided.

The organometallic compound represented by any one of Formulas 1-1 to 1-4 necessarily includes at least one substituent, such $R_{11}$ which has a relatively low breaking energy of C-H bond, and thus have improved photosensitivity to high-energy rays, particularly to EUV.

The organometallic compound may be produced by any suitable method.

A structure (a composition) of the organometallic compound can be observed by performing FT-IR analysis, NMR analysis, fluorescence X-ray (XRF) analysis, mass spectrometry, UV analysis, single crystal X-ray structure analysis, powder X-ray diffraction (PXRD) analysis, liquid chromatography (LC) analysis, size exclusion chromatography (SEC) analysis, thermal analysis, etc. The detailed verification method is as described as in an embodiment.

**[Resist composition]**

According to another aspect, a resist composition including the above-described organometallic compound is provided. The resist composition may have improved characteristics of photosensitivity and/or storage stability.

When exposed to high-energy rays, the solubility of the resist composition in a developing solution changes. The resist composition may be a negative-type resist composition in which an unexposed portion of a resist film is dissolved and removed to form a negative-type resist pattern.

In addition, a resist composition according to an embodiment may be for an alkaline development process using an alkaline developing solution for developing treatment in forming a resist pattern, and may be for a solvent development process using a developing solution containing an organic solvent (hereinafter referred to as an organic developing solution) for the developing treatment.

The resist composition is a non-chemically amplified resist composition, and therefore no photoacid generator may be substantially included.

In the resist composition, the organometallic compound changes in physical properties by exposure, and thus substantially does not include compound having a molecular weight of about 1000 or more except for the aforementioned organometallic compound may be included.

In the resist composition, the organometallic compound may be included in an amount of about 0.1 parts by weight to about 100 parts by weight, In some embodiments, 0.2 parts by weight or more, 0.5 parts by weight or more, 1 part by weight or more, 2 parts by weight or more, 90 parts by weight or less, or 80 parts by weight or less, with respect to 100 parts by weight of the composition. When the amount of the organometallic compound satisfies the above-mentioned range, a side reaction is suppressed while sufficiently forming a chemical bond between organometallic compounds, thereby providing a resist composition having improved sensitivity and/or resolution.

<Organic solvent>

The resist composition may further include an organic solvent.

The organic solvent included in the resist composition is not particularly limited as long as being capable of dissolving or dispersing the organometallic compound and any optional components contained as needed. The organic solvent may be used alone, or used in a combination of two or more different types of organic solvents.

According to an embodiment, the organic solvent may include an aprotic organic solvent.

According to another embodiment, the organic solvent may be a mixture of an aprotic organic solvent and a protic organic solvent.

Since the resist composition may not substantially include water, the organic solvent may not include water. In some embodiments, the resist composition may include at most 3 wt % of water, and the organic solvent may include at most 3 wt% of water.

Examples of organic solvents may include an alcohol-based solvent, an ether-based solvent, a ketone-based solvent, an amide-based solvent, an ester-based solvent, a sulfoxide-based solvent, a hydrocarbon-based solvent, etc.

In some embodiments, examples of the alcohol-based solvent may include: a mono alcohol-based solvent such as methanol, ethanol, n-propanol, isopropanol, 1-methoxy-2-propanol, 1-ethoxy-2-propanol, n-butanol, isobutanol, sec-butanol, tert-butanol, n-pentanol, isopentanol, 2-methylbutanol, sec-pentanol, tert-pentanol, 3-methoxybutanol, 3-methyl-3-methoxybutanol, n-hexanol, 2-methylpentanol, sec-hexanol, 2-ethylbutanol, 4-methyl-2-pentanol (MIBC), sec-heptanol, 3-heptanol, n-octanol, 2-ethylhexanol, sec-octanol, n-nonyl alcohol, 2,6-dimethyl-4-heptanol, n-decanol, sec-undecyl alcohol, trimethylnonyl alcohol, sec-tetradecyl alcohol, sec-heptadecyl alcohol, furfuryl alcohol, phenol, cyclohexanol, methylcyclohexanol, 3,3,5-trimethylcyclohexanol, benzyl alcohol, diacetone alcohol, etc; a polyhydric alcohol-based solvent such as ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, etc; a polyhydric alcohol-containing ether-based solvent such as an ethylene glycol monomethyl ether, ethylene glycol monoethyl ether, ethylene glycol monopropyl ether, ethylene glycol monobutyl ether, ethylene glycol monohexyl ether, ethylene glycol monophenyl ether, ethylene glycol mono-2-ethylbutyl ether, diethylene glycol monomethyl ether, diethylene glycol monoethyl ether, diethylene glycol monopropyl ether, diethylene glycol monobutyl ether, diethylene glycol monohexyl ether, diethylene glycol dimethyl ether, propylene glycol monomethyl ether, propylene glycol dimethyl ether, propylene glycol monoethyl ether, propylene glycol monopropyl ether, propylene glycol monobutyl ether, dipropylene glycol monomethyl ether, dipropylene glycol monoethyl ether, dipropylene glycol monopropyl ether, etc.

Examples of an ether-based solvent may include: a dialkyl ether-based solvent such as diethyl ether, dipropyl ether, dibutyl ether, etc; a cyclic ether-based solvent such as tetrahydrofuran, tetrahydropyran, etc; and an aromatic ring-containing ether-based solvent such as diphenyl ether, anisole, etc.

Examples of a ketone-based solvent may include: a chain ketone-based solvent such as acetone, methyl ethyl ketone, methyl-n-propyl ketone, methyl-n-butyl ketone, methyl-n-pentyl ketone, diethyl ketone, methylisobutyl ketone, 2-heptanone, ethyl-n-butyl ketone, methyl-n-hexyl ketone, diisobutyl ketone, trimethyl nonanone, etc; a cyclic ketone-based solvent such as cyclopentanone, cyclohexanone, cycloheptanone, cyclooctanone, methylcyclohexanone, etc; 2,4-phentandion, acetonylaceton, acetphenon, etc.

Examples of an amid-based solvent may include: a cyclic amide-based solvent such as N, N'-dimethyl imidazolidinone N-methyl-2-pyrrolidone, etc; a chain amide-based solvent such as N-methyl formamide, N, N-dimethyl formamide, N, N-diethyl formamide, acetamide, N-methyl acetamide, N, N-dimethyl acetamide, N-methyl propionamide, etc.

Examples of the ester-based solvent may include: an acetate ester-based solvent such as methyl acetate, ethyl acetate, n-propyl acetate, isopropyl acetate, n-butyl acetate, isobutyl acetate, sec-butyl acetate, t-butyl acetate, n-pentyl acetate, isopentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, etc; a polyhydric alcohol-containing ether carboxylate-based solvent such as ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate (PGMEA), propylene glycol monopropyl ether acetate, propylene glycol monobutyl ether acetate, dipropylene glycol monomethyl ether acetate, dipropylene glycol monoethyl ether acetate, etc; a lactone-based solvent such as γ-butyrolactone and δ-valerolactone; a carbonate-based solvent such as dimethyl carbonate, diethyl carbonate, ethylene carbonate, and propylene carbonate; a lactate ester-based solvent such as methyl lactate, ethyl lactate, n-butyl lactate, n-amyl lactate, etc; glycoldiacetate, methoxytriglycol acetate, ethyl propionate, n-butyl propionate, isoamyl propionate, diethyloxalate, di-n-butyloxalate, methyl acetoacetate, ethyl acetoacetate, diethyl malonate, dimethyl phthalate, diethyl phthalate, etc.

Examples of a sulfoxide-based solvent may include dimethyl sulfoxide, diethyl sulfoxide, etc.

Examples of a hydrocarbon-based solvent may include an aliphatic hydrocarbon-based solvent such as n-pentane, isopentane, n-hexane, isohexane, n-heptane, isoheptane, 2,2,4-trimethylpentane, n-octane, isooctane, cyclohexane, methylcyclohexane, etc; an aromatic hydrocarbon-based solvent such as benzene, toluene, xylene, mesitylene, ethylbenzene, trimethylbenzene, methylethylbenzene, n-propylbenzene, isopropylbenzene, diethylbenzene, isobutylbenzene, triethylbenzene, diisopropylbenzene, n-amylnaphthalene, etc.

In some embodiments, the organic solvent may be selected from the alcohol-based solvent, the ketone-based solvent, the ester-based solvent, and any combination thereof. In some embodiments, the solvent may be selected from 4-methyl-2-pentanol (MIBC), propylene glycol monomethyl ether, propylene glycol monoethyl ether, propylene glycol monomethyl ether acetate, ethyl lactate, cyclohexanone and any combination thereof.

<Optional components>

The resist composition may further include a surfactant, a cross-linker, a leveling agent, a colorant, or any combination thereof, as needed.

The resist composition may further include the surfactant in order to improve the applicability, developability, etc. Specific examples of the surfactant may include, for example, non-ionic surfactant such as polyoxyethylene lauryl ether, polyoxyethylene stearyl ether, polyoxyethylene oleyl ether, polyoxyethylene n-octylphenyl ether, polyoxyethylene n-nonylphenyl ether, polyethylene glycol dilaurate, polyethylene glycol distearate, etc. As the surfactant, a commercially available product or a synthetic product may be used. Examples of the commercially available product of the surfactant may include KP341 (manufactured by Shin-Etsu Chemical Co., Ltd.), Polyflow No.75, Polyflow No.95 (hitherto, manufactured by Kyoeisha Chemical Co., Ltd.), Ftop EF301, Ftop EF303, Ftop EF352 (hitherto, manufactured by Mitsubishi Material Electronics Hwaseong Co., Ltd.), MEGAFACE (registered trademark) F171, MEGAFACE F173, R40, R41, R43 (hitherto, manufactured by DIC Corporation), Fluorad (registered trademark) FC430, Fluorad FC431 (hitherto, manufactured by 3M), AsahiGuard AG710 (manufactured by AGC Corporation), Surflon (registered trademark) S-382, Surflon SC-101, Surflon SC-102, Surflon SC-103, Surflon SC-104, Surflon SC-105, Surflon SC-106 (hitherto, manufactured by AGC Semi Chemical Co., Ltd.), etc.

The surfactant may be included in an amount of about 1 part by weight to about 20 parts by weight with respect to 100 parts by weight of the polymer. The surfactant may be used alone, or used in a mixture of two or more different types of the surfactants.

A preparation method of the resist composition is not particularly limited, and for example, and a method of mixing a polymer and optional components added as required, in an organic solvent may be used. A mixing temperature or time is not particularly limited. Filtration may be performed after mixing as needed.

**[Pattern forming method]**

Hereinafter, a pattern forming method according to embodiments will be described in more detail with reference to FIGS. 1 and 2. FIG.1 is a flowchart illustrating a pattern forming method according to embodiments, and FIG.2 is a side cross-sectional view illustrating a pattern forming method according to embodiments. Hereinafter, a pattern forming method using a negative resist composition will be concretely described as an example, but is not limited thereto.

Referring to FIG. 1, the pattern forming method includes applying a resist composition to form a resist film (S101) on a substrate, exposing at least a portion of the resist film by high-energy rays (S102), and developing an exposed resist film using a developing solution (S103). If necessary, above-mentioned processes may be omitted, or may be performed in a different order.

First, referring to FIG. 2A, a substrate 100 was prepared. Examples of the substrate 100 may include a semiconductor substrate such as a silicon substrate and a germanium substrate, a glass substrate, a quartz substrate, a ceramic substrate, a copper substrate, etc. In some embodiments, the substrate 100 may include a III-V group compound such as GaP, GaAs, GaSb.

Referring to FIG. 1 (S101) and FIG. 2A, a resist film 110 may be formed by applying the resist composition through a specific coating method to a desired thickness onto the substrate 100. As needed, a thermal process (pre-bake, PB) may also be performed to remove an organic solvent remaining on the resist film 110. Alternatively, a radical may be generated by heating the resist film 110, and then, when exposed, a crosslink may be formed by a chemical bond of radicals.

As the coating method, spin coating, dip-coating, roller coating or other general coating methods may be used. Among these methods, particularly, spin coating may be used, and the resist film 110 having a desired thickness may be formed by controlling the viscosity, concentration and/or spin speed of the resist composition. In some embodiments, the resist film 110 may have a thickness of about 10 nm to about 300 nm. In some embodiments, the resist film 110 may have a thickness of about 30 nm to about 200 nm.

The lower limit temperature for pre-bake may be at least 60 °C, or 80 °C or more. In addition, the upper limit temperature for pre-bake may be at most 150 °C, or 140 °C or less. The lower limit time for pre-bake may be at least 5 seconds, or 10 seconds or more. The upper limit time for pre-bake may be at most 600 seconds, or 300 seconds or less.

Before applying the resist composition on the substrate 100, an etching target film (not shown) may be further formed on the substrate 100. The etching target film may mean a layer on which an image is transferred from a resist pattern and converted to a desired and/or alternatively predetermined pattern. According to an embodiment, the etching target film may be formed to include, for example, an insulating material, such as silicon oxide, silicon nitride, and silicon oxynitride. According to some embodiments, the etching target film may be formed to include a conductive material such as a metal, a metal nitride, a metal silicide, and a metal silicide nitride film. According to some embodiments, the etching target film may be formed to include a semiconducting material such as polysilicon.

According to an embodiment, an antireflection film may be further formed on the substrate 100 in order to maximize the efficiency of the resist. The antireflection film may be an organic or inorganic antireflection film.

According to an embodiment, a protective film may be further formed on the resist film 100 to reduce an impact of alkaline impurities included in processes, etc. In addition, when performing a liquid immersion exposure, the protective film for a liquid immersion may be provided, for example, on the resist film 100 to avoid direct contact between a liquid immersion medium and the resist film 100.

Next, referring to FIG. 1 (S102) and FIG. 2B, at least a portion of the resist film 100 may be exposed with high-energy rays. For example, at least a portion of the resist film 110 may be irradiated with the high-energy rays that have passed through a mask 120. As a result, the resist film 110 may have an exposed portion 111 and an unexposed portion 112.

Although not limited to a specific theory, radicals may be generated from the exposed portion 111 due to exposure, a chemical bond between the radicals may be formed, and thus the physical properties of the resist composition may change.

In some cases, the exposure is performed by using a liquid medium such as water and irradiating high-energy rays through a mask having a desired and/or alternatively predetermined pattern. Examples of the high-energy rays may include: electromagnetic waves, such as ultraviolet rays, far-ultraviolet rays, extreme ultraviolet (EUV, wavelength 13.5 nm) rays, X-rays, and $\gamma$-rays; and charged particle beams such as electron beams (EB) and a-particles. An irradiation of the high-energy rays may be collectively referred to as an "exposure".

Examples of various light sources used for an exposure may include: a light source emitting laser light in the ultraviolet range such as KrF excimer laser (wavelength of 248 nm), ArF excimer laser (wavelength of 193 nm), or $F_2$ excimer laser (wavelength of 157 nm); a light source emitting harmonic laser light in the far ultraviolet or vacuum ultraviolet range by converting the wavelength of laser light from a solid-state laser light source (such as YAG or semiconductor laser); and a light source emitting electron beams or extreme ultraviolet (EUV) rays. When exposed, the exposure may be normally performed through a mask corresponding to a desired pattern. However, when the light source is an electron

beam, the exposure may be directly performed by drawing without using the mask.

When extreme ultraviolet lights are used as the high-energy rays, an accumulated dose of high-energy rays may be, for example, 2000 $mJ/cm^2$ or less, or 500 $mJ/cm^2$ or less. In addition, when electron beams are used as the high-energy rays, the accumulated dose may be 5000 $pC/cm^2$ or less, or 1000 $\mu C/cm^2$ or less.

In addition, post exposure bake (PEB) may be performed after the exposure. The lower limit temperature for PEB may be at least 50 °C, or 80 °C or more. The upper limit temperature for PEB may be at most 250 °C, or 200 °C or less. The lower limit temperature for PEB may be at least 5 seconds, or 10 seconds or more. The upper limit temperature for PEB may be at most 600 seconds, or 300 seconds or less.

Next, referring to FIG. 1 (S103) and FIG. 2C, the exposed resist film 110 may be developed by using a developing solution. The unexposed portion 112 may be washed away by the developing solution, the exposed portion 111 may be not washed away by the developing solution and remain.

Examples of the developing solution, may include an alkaline developing solution, a developing solution including an organic solvent (hereinafter, also referred to as an "organic developing solution", etc. Examples of a developing method may include a dipping method, a puddle method, a spray method, and a dynamic dosing method. For example, the developing temperature may be about 5 °C to about 60 °C, the developing time may be about 5 seconds to about 300 seconds.

Examples of alkaline developing solutions may include an alkaline aqueous solution in which one or more kinds of alkaline compounds, such as sodium hydroxide, potassium hydroxide, sodium carbonate, sodium silicate, sodium metasilicate, aqueous ammonia, ethylamine, n-propylamine, diethylamine, di-n-propylamine, triethylamine, methyl diethylamine, ethyl dimethylamine, triethanol amine, tetramethyl ammonium hydroxide (TMAH), pyrrole, piperidine, choline, 1,8-diazabicyclo[5.4.0]-7-undecene (DBU), 1,5-diazabicyclo[4.3.0]-5-nonene (DBN), are dissolved. Examples of the alkaline developing solutions may further include a surfactant.

A lower limit amount of the alkaline compound in the alkaline developing solution may be at least about 0.1 wt%, about 0.5 wt% or more, or about 1 wt % or more. In addition, the upper limit amount of the alkaline compound in the alkaline developing solution may be at most about 20 wt%, about 10 wt% or less, or about 5 wt% or less.

As the organic solvent included in the organic developing solution, for example, the same organic solvent as those in the <Organic solvent> part of [Resist composition] may be used. In some embodiments, nBA (n-butyl acetate), PGME (propylene glycol methyl ether), PGMEA (propylene glycol methyl ether acetate), GBL ($\gamma$-butyrolactone), IPA (isopropanol), and the like may be used as the organic developing solution. The organic developing solution may further include an organic acid such as acetic acid, formic acid, or citric acid.

A lower limit amount of the organic solvent in the organic developing solution may be at least about 80 wt%, about 90 wt% or more, about 95 wt% or more, or about 99 wt% or more.

The organic developing solvent may include a surfactant. In addition, the organic developing solution may include small amount of moisture. Additionally, when developed, developing may be stopped by substituting the organic developing solution by a different type of a solvent.

A resist pattern after developing may be further cleaned. Ultrapure water, a rinse solution etc., may be used as a cleaning solution. The rinse solution is not particularly limited unless the rinse solution dissolves the resist pattern, a solution including an general organic solvent may be used. For example, the rinse solution may be an alcohol-based solvent or a ester-based solvent. After cleaning, any residual rinse solution on the substrate and the pattern may be removed. In addition, when using ultrapure water, water remaining on the substrate or the pattern may be removed.

In addition, a developing solution may be used alone or used in a combination of two or more.

After the resist pattern is formed as described above, and then etched, thereby obtaining a patterned wiring substrate. Etching may be performed through known methods such as a dry etching method using a plasma gas, wet etching method using an alkali solution, copper(II) chloride solution, iron(III) chloride solution.

After the resist pattern is formed, plating may be performed. A plating method is not particularly limited, and may include, for example, copper plating, solder plating, nickel plating, gold plating, etc.

A resist pattern remaining after etching may be stripped with the organic solvent. Examples of the organic solvents may include, although not particularly limited, propylene glycol monomethyl ether acetate (PGMEA), propylene glycol monomethyl ether (PGME), ethyl lactate (EL), etc. Although not particularly limited, examples of stripping methods include an immersion method, a spray method, etc. In addition, the wiring substrate on which the resist pattern is formed may be a multilayer wiring substrate and may have a small-diameter through-hole.

According to an embodiment, the wiring substrate may also be formed by a lift-off method, in which a metal is deposited in a vacuum after forming the resist pattern, and then the resist pattern is dissolved in a solution.

FIGS. 5A to 5E are side cross-sectional views illustrated a method of forming a patterned structure according to an embodiment.

The method in FIGS. 5A to 5E may be the same as the method in FIGS. 2A to 2C, except for the differences described below.

Referring to FIG. 5A, a material layer 130 may be formed on the substrate 100 before forming a resist film 110

on the substrate 100. The resist film 110 may be formed on top of the material layer 130. The material layer 130 may include an insulating material (e.g., silicon oxide, silicon nitride), a semiconductor material (e.g., silicon), a metal (e.g., copper). In some embodiments, the material layer 130 may be a multi-layer structure. A material of the material layer 130 may be different than a material of the substrate 100.

Referring to FIG. 5B, the resist film 110 may be exposed with high energy rays through a mask 120, after which the resist film 110 may include exposed areas 111 and unexposed areas 112.

Referring to FIG. 5C, the exposed resist film 110 may be developed by using a developing solution. The exposed area 111 may be washed away by the developing solution, whereas the unexposed area 112 may remain without being washed away by the developing solution.

Referring to FIG. 5D, exposed areas of the material layer 130 may be etched using the resist film 110 as a mask to form a material pattern 135 on the substrate 100.

Referring to FIG. 5E, the resist film 110 may be removed.

A resist composition including the above-described organometallic compound according one or more embodiments may be used in a patterning process to form various types of semiconductor devices.

The disclosure will be described in more detail with reference to the following Examples and Comparative Examples, but the technical scope of the disclosure is not limited only to the following Examples.

**[Example]**

**Synthesis Example 1: Synthesis of SM1**

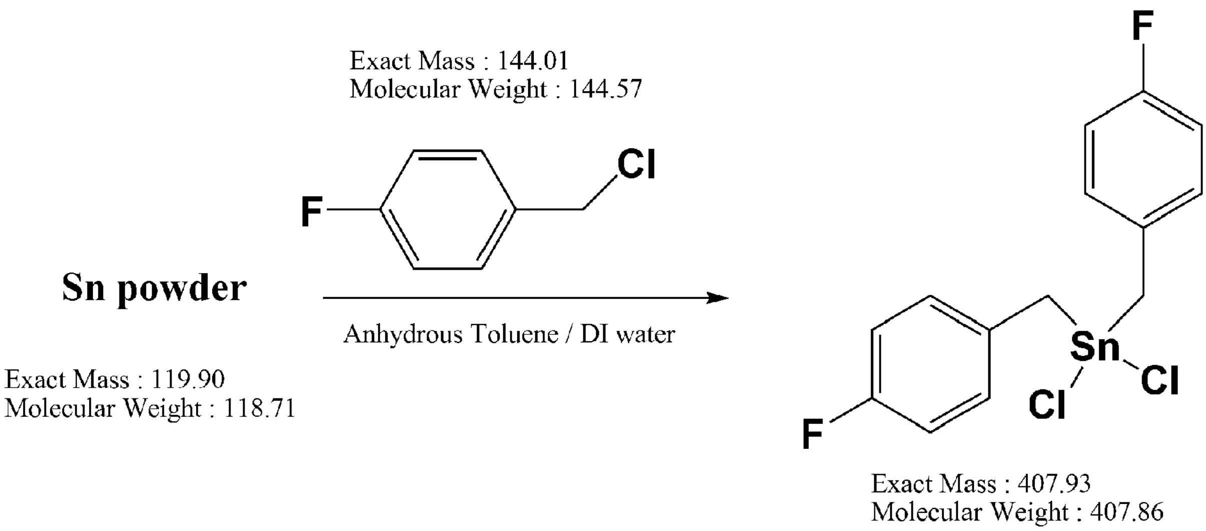


8.2 g (69.2 mmol) of Sn powder and 120ml of dry toluene were added in a 250 ml three-necked flask and the temperature was raised to 90 °C. 1.0 ml of DI water was added, and then 10.0 g (69.2 mmol) of 4-fluorobenzyl chloride was added dropwise for 10 minutes. After heating to reflux and stirring at 130 °C for 4 hours, an unreacted Sn power was filtered out using a Buchner funnel. At the same time, the filtered solution was cooled to obtain 6.5 g (yield of 36%) of white crystals (SM1 precursor) as a product.

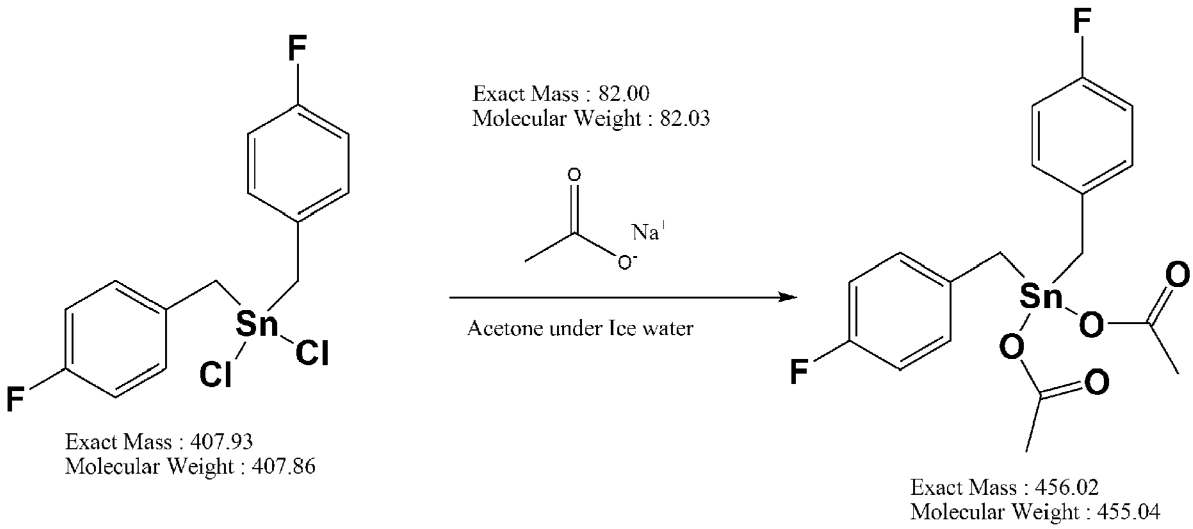


1.5 g (3.7 mmol) of an SM1 precursor and 21.0 ml of dry acetone were added to a 50 ml single-necked flask, and then the temperature was lowered to 0 °C. 0.6 g (7.4 mmol) of sodium acetate was added, and then the resultant mixture was stirred for 12 hours. A NaCl salt produced in the solution was filtered out using a 0.45 μm filter, and then the filtered solution was concentrated by rotary evaporator and dried in vacuum to obtain SM1 (1.6 g) at a yield of 74%. The obtained SM1 was analyzed by $^1$H-NMR, and analyzed results were shown in FIG. 3A.

$^1$H-NMR (500 MHz, DMSO-$d_6$): δ ~6.9 (8H), ~2.6 (4H), -1.6 (6H)

**Synthesis Example 1: Synthesis of SM2**

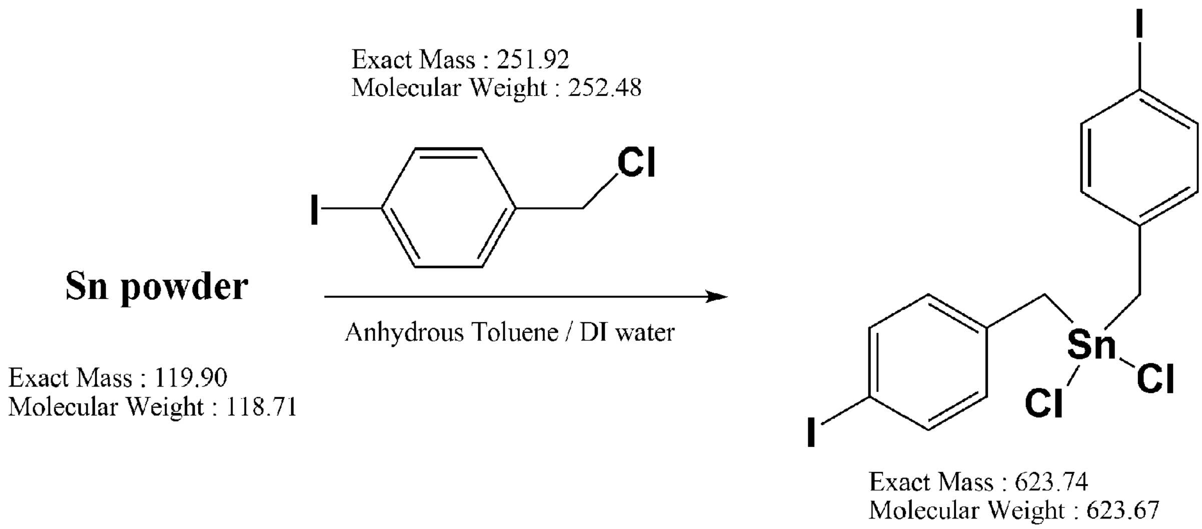


8.2 g (69.2 mmol) of Sn powder and 120ml of dry toluene were added in a 250 ml three-necked flask and the temperature was raised to 90 °C. 1.0 ml of DI water was added, and then 5.0 g (19.9 mmol) of 4-iodobenzyl chloride was added dropwise for 10 minutes. After heating to reflux and stirring at 130 °C for 4 hours, an unreacted Sn power was filtered out using a Buchner funnel. At the same time, the filtered solution was cooled to obtain 1.7 g (yield of 36%) of white crystals (SM2 precursor) as a product.

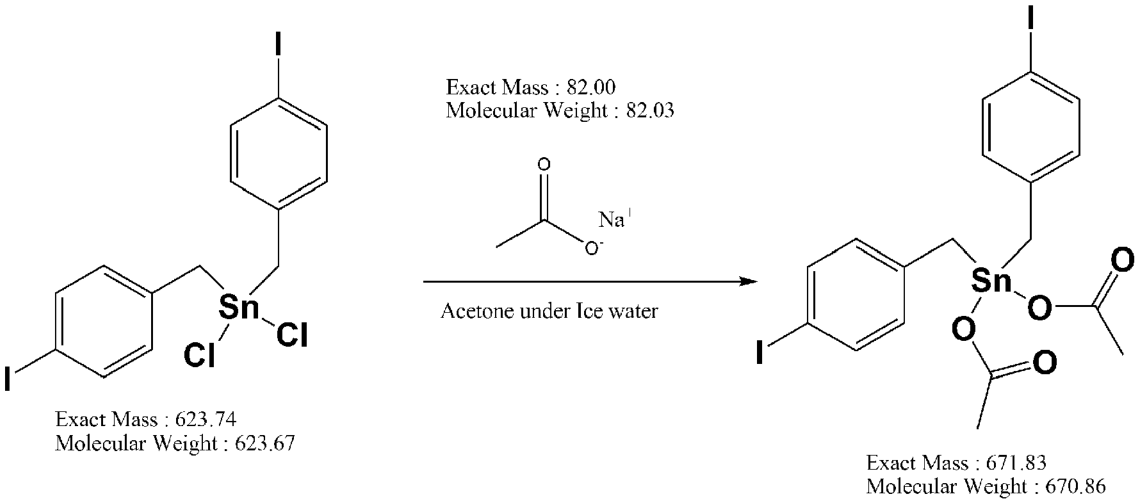


1.7 g (2.7 mmol) of an SM2 precursor and 42.9 ml of dry acetone were added to a 100 ml single-necked flask, and then the temperature was lowered to 0 °C. 0.6 g (7.4 mmol) of sodium acetate was added, and then the resultant mixture was stirred for 12 hours. A NaCl salt produced in the solution was filtered out using a 0.45-μm filter, and then the filtered solution was concentrated by rotary evaporator and dried in vacuum to obtain SM2 (1.8 g) at a yield of 84%. The obtained SM2 was analyzed by $^1$H-NMR, and analyzed results were illustrated in FIG. 3B.
$^1$H-NMR (500 MHz, DMSO-$d_6$): δ ~7.4/6.7 (8H), ~2.5 (4H), -1.6 (6H)

**Synthesis Example 3: Synthesis of SM3**

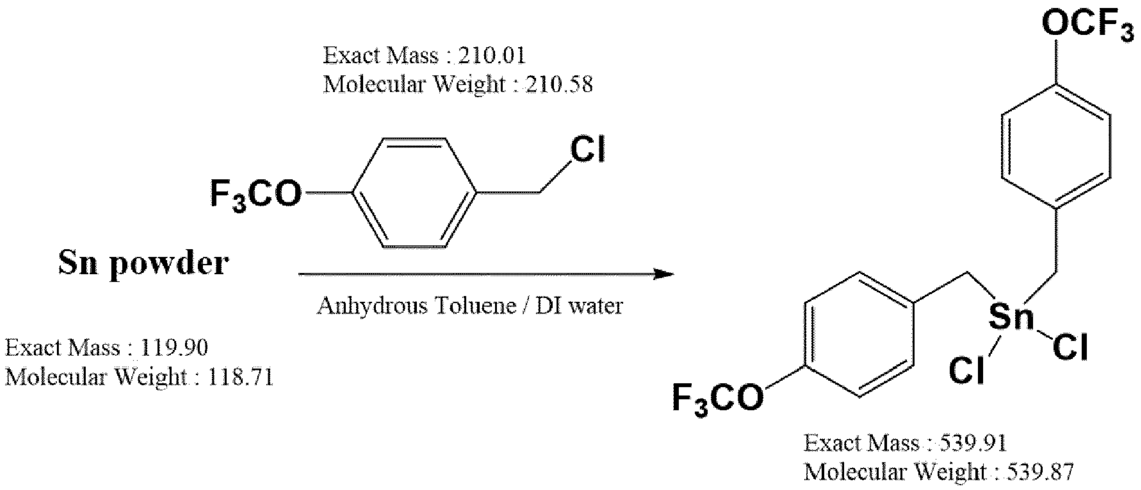


8.2 g (69.2 mmol) of Sn powder and 120ml of dry toluene were added in a 250 ml three-necked flask and the temperature was raised to 90 °C. 1.0 ml of DI water was added, and then 10.7 g (50.7 mmol) of 4-(trifluoromethoxybenzyl) chloride was added dropwise for 10 minutes. After heating to reflux and stirring at 130 °C for 4 hours, an unreacted Sn power was filtered out using a Buchner funnel. The filtered solution was crystallized at -20 °C for about 3 days to about 6 days, followed by being concentrated by rotary evaporator and dried in vacuum to obtain 3.7 g of white crystals (SM3 precursor) as a product (yield of 35%).

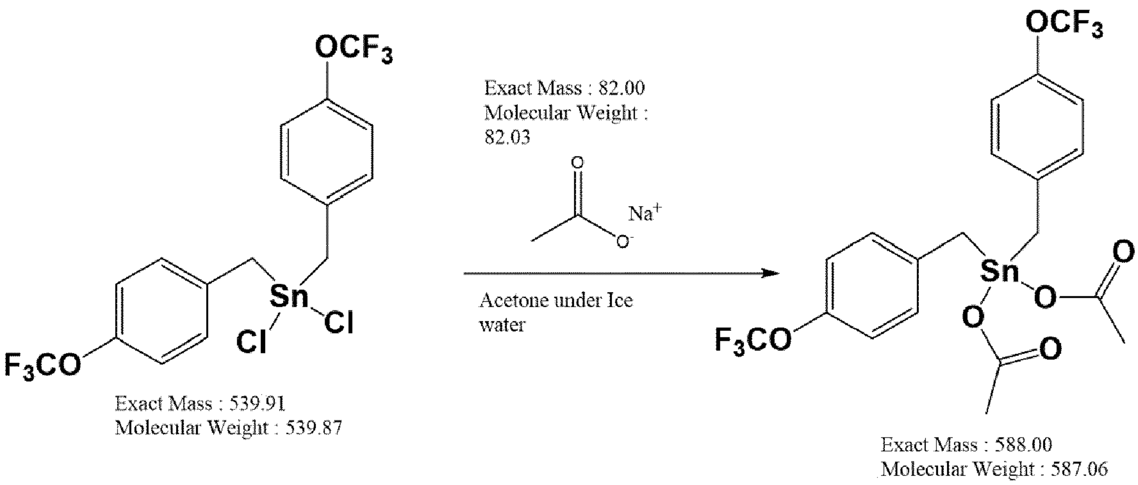


2.0 g (3.7 mmol) of SM3 precursor and 26.1 ml of dry acetone were added to a 50 ml single-necked flask, and then the temperature was lowered to 0 °C. 0.6 g (7.4 mmol) of sodium acetate was added, and then the resultant mixture was stirred for 12 hours. A NaCl salt produced in the solution was filtered out using a 0.45-μm filter, and then the filtered solution was concentrated by rotary evaporator and dried in vacuum to obtain SM3 (1.9 g) at a yield of 74% d. The obtained SM3 was analyzed by 1H-NMR and analyzed result were illustrated in FIG. 3C.
$^1$H-NMR (500 MHz, DMSO-$d_6$): δ ~7.0 (8H), ~2.6 (4H), ~1.4 (6H)

**Evaluation Example: thin film development evaluation**

In some embodiments, the organometallic compound synthesized in Synthesis Examples 1 to 3 was dissolved in an amount of 2 % by weight in a casting solvent listed in Table 1 below. The casting solution was spin-coated at 1500 rpm on a silicon wafer coated with a 3 nm of HMDS as a lower film, and the resultant was dried at 120 °C for 1 minute to produce a film having an initial thickness in Table 1 below. Next, the produced film was exposed to DUV in a wavelength of 254 nm with a dose of about 0 mK/$cm^2$ to about 40 mJ/$cm^2$, then dried at 200 °C for 1 minute. The dried film was soaked at 25 °C for 60 seconds using a PGMEA solution in which 2 wt% of acetic acid was dissolved as the developing solution, and then a thickness of the remaining film was measured and shown in Table 2 and FIGS. 4A to 4E below.

Table 1

| | Organic metal Compound | Casting solvent | PAB (°C) | Initial thickness (nm) | PEB (°C) |
|---|---|---|---|---|---|
| Comparative Example 1 | OM | Ethyl lactate | 120 | 25 | 200 |
| Comparative Example 2 | OM1 | xylene | 120 | 23 | 200 |
| Example 1 | SM1 | Ethyl lactate | 120 | 25 | 200 |
| Example 2 | SM2 | Cyclohexanone | 120 | 22 | 200 |
| Example 3 | SM3 | 4-methyl-2-pentanol | 120 | 25 | 200 |

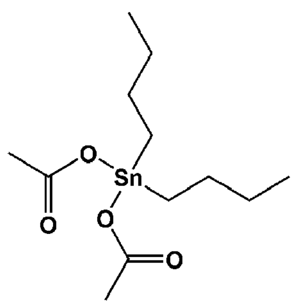

OM

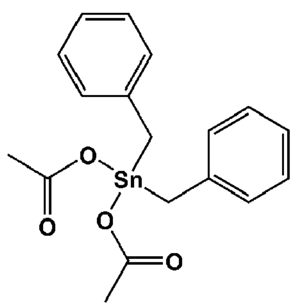

OM1

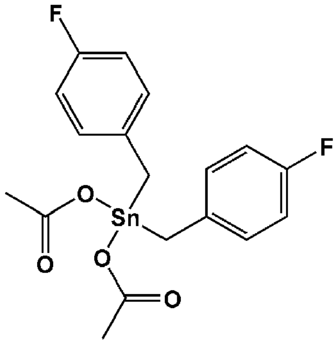

SM1

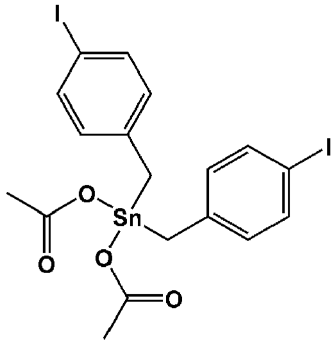

SM2

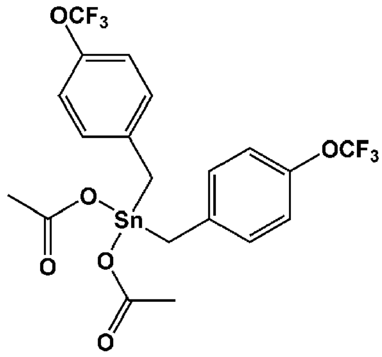

SM3

Table 2

| | Organic metal Compound | $E_{th}$ (mJ) | $E_1$ (mJ) | Y |
|---|---|---|---|---|
| Comparative Example 1 | OM | ≥100 | ≥100 | - |
| Comparative Example 2 | OM1 | 15 | 35 | 2.7 |
| Example 1 | SM1 | 12.5 | 30 | 2.6 |
| Example 2 | SM2 | 12.5 | 27.5 | 2.9 |
| Example 3 | SM3 | 17.5 | 30 | 4.3 |

In above Table 2, $E_{th}$ means an exposure amount at the time when the thin film starts to be hardened, and $E_1$ means an exposure amount at a saturation point at which the thickness of the thin film no longer increases. The film remaining ratio is a value obtained by dividing the thickness of the thin film at the saturation point by an initial thickness of the thin film as a percentage, and $\gamma$ is a contrast curve, which is a value calculated in accordance with Equation 1 below.

<Equation 1>

$$\gamma = \left| \log \left( \frac{E_{th}}{E_1} \right) \right|^{-1}$$

Referring to Table 2, it can be seen that Examples 1 to 3 exhibits smaller values of $E_{th}$ and/or $E_1$ and larger $\gamma$ value than those of Comparative Examples 1 and 2. Accordingly, it can be confirmed that the resist compositions according to Examples 1 to 3 have improved photosensitivity than those of Comparative Examples 1 and 2. Herein, in Comparative Example 1, since values of $E_{th}$ and $E_1$ cannot be determined, $\gamma$ cannot be calculated.

According to embodiments, a resist composition having improved sensitivity and providing patterns with improved resolution may be provided.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An organometallic compound represented by any one of Formulas 1-1 to 1-4 below:

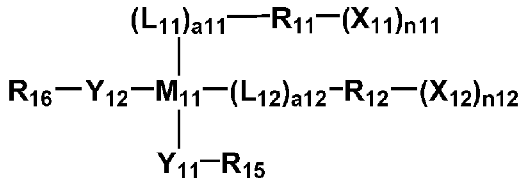

1-1

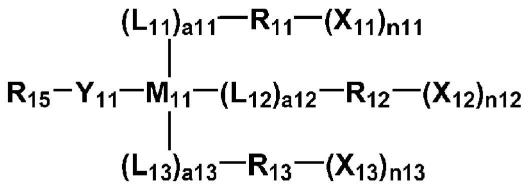

1-2

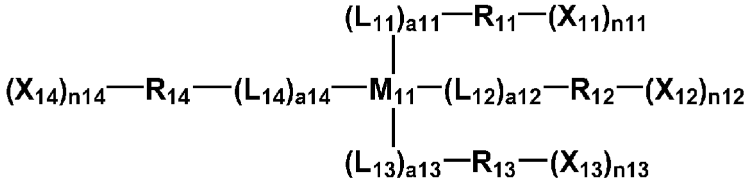

1-3

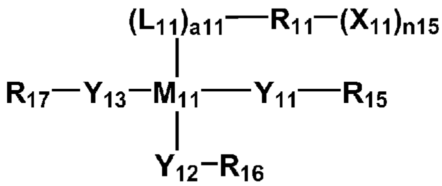

1-4

wherein, in Formulas 1-1 to 1-4,

$M_{11}$ is indium (In), tin (Sn), antimony (Sb), tellurium (Te), thallium (Tl), lead (Pb), bismuth (Bi), or polonium (Po),
$L_{11}$ to $L_{14}$ are each independently a single bond, or a linear, branched or cyclic $C_1$-$C_{30}$ divalent hydrocarbon group,
a11 to a14 are each independently an integer of 1 to 4,
$R_{11}$ and $R_{14}$ are each independently a substituted or unsubstituted $C_3$-$C_{30}$ cycloalkyl group, a substituted or unsubstituted $C_3$-$C_{30}$ heterocycloalkyl group, a substituted or unsubstituted $C_2$-$C_{30}$ alkenyl group, a substituted or unsubstituted $C_3$-$C_{30}$ cycloalkenyl group, a substituted or unsubstituted $C_3$-$C_{30}$ heterocycloalkenyl group, a substituted or unsubstituted $C_2$-$C_{30}$ alkynyl group, a substituted or unsubstituted $C_6$-$C_{30}$ aryl group, or a substituted or unsubstituted $C_1$-$C_{30}$ heteroaryl group,
$X_{11}$ to $X_{14}$ are each independently a halogen, a hydroxyl group, a cyano group, a nitro group, a carboxylic acid group, a linear, branched or cyclic monovalent $C_1$-$C_{30}$ hydrocarbon group that optionally contains a heteroatom, or $-N(Q_1)(Q_2)$,
n11 to n14 are each independently an integer of 0 to 10,
n15 is an integer of 1 to 10,
in Formula 1-1, a sum of n11 and n12 is 1 or more,
in Formula 1-2, a sum of n11, n12 and n13 is 1 or more,
in Formula 1-3, a sum of n11, n12, n13 and n14 is 1 or more,
$Y_{11}$ to $Y_{13}$ are each independently O, S or $NR_{18}$,
$R_{15}$ to $R_{18}$, $Q_1$, and $Q_2$ are each independently, hydrogen, deuterium, or a linear, branched or cyclic monovalent $C_1$-$C_{30}$ hydrocarbon group that optionally contains a heteroatom.

**2.** The organometallic compound of claim 1, wherein
$M_{11}$ is In, Sn, or Sb.

**3.** The organometallic compound of claims 1 or 2,
wherein $L_{11}$ to $L_{14}$ are each independently a single bond, a substituted or unsubstituted $C_1$-$C_{30}$ alkylene group, a substituted or unsubstituted $C_3$-$C_{30}$ cycloalkylene group, a substituted or unsubstituted $C_3$-$C_{30}$ heterocycloalkylene group, a substituted or unsubstituted $C_2$-$C_{30}$ alkenylene group, a substituted or unsubstituted $C_3$-$C_{30}$ cycloalkenylene group, a substituted or unsubstituted $C_3$-$C_{30}$ heteroalkenylene group, a substituted or unsubstituted $C_6$-$C_{30}$ arylene group, or a substituted or unsubstituted $C_1$-$C_{30}$ cycloarylene group.

**4.** The organometallic compound of any of claims 1-3, wherein
$R_{11}$ to $R_{14}$ are each independently selected from a $C_3$-$C_{30}$ cycloalkyl group, a $C_3$-$C_{30}$ heterocycloalkyl group, a $C_2$-$C_{30}$ alkenyl group, a $C_3$-$C_{30}$ cycloalkenyl group, a $C_3$-$C_{30}$ heterocycloalkenyl group, a $C_2$-$C_{30}$ alkynyl group, a $C_6$-$C_{30}$ aryl group, and a $C_1$-$C_{30}$ heteroaryl group, and
$R_{11}$ to $R_{14}$ independently are each unsubstituted or substituted with deuterium, a halogen, a hydroxyl group, a cyano group, a nitro group, an amino group, a carbonyl group, a carboxyl acid group, an ether moiety, an ester moiety, a sulfonate ester moiety, a carbonate moiety, an amide moiety, a lactone moiety, a sultone moiety, a carboxylic

anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group, or any combination thereof.

**5.** The organometallic compound of any of claims 1-4, wherein

$X_{11}$ to $X_{14}$ are each independently selected from a halogen, a hydroxyl group, a cyano group, a nitro group, a carboxyl acid group, a $C_1$-$C_{30}$ alkyl group, a $C_1$-$C_{30}$ halogenated alkyl group, a $C_1$-$C_{30}$ alkoxy group, a $C_1$-$C_{30}$ alkylthio group, a $C_1$-$C_{30}$ halogenated alkoxy group, a $C_1$-$C_{30}$ halogenated alkylthio group, a $C_3$-$C_{30}$ cycloalkyl group, a $C_3$-$C_{30}$ cycloalkoxy group, and a $C_3$-$C_{30}$ cycloalkylthio group, $X_{11}$ to $X_{14}$ independently are each unsubstituted or substituted by deuterium, a halogen, a hydroxy group, a cyano group, a nitro group, an amino group, a carbonyl group, a carboxylic acid group, an ether moiety, a ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group, or any combination thereof, and - $N(Q_1)(Q_2)$,

$Q_1$ and $Q_2$ are each independently selected from: hydrogen; deuterium; and a $C_1$-$C_{30}$ alkyl group, a $C_3$-$C_{30}$ cycloalkyl group, a $C_3$-$C_{30}$ cycloalkenyl group, and a $C_6$-$C_{30}$ aryl group, each being unsubstituted or substituted with deuterium, a halogen, a hydroxy group, a cyano group, a nitro group, an amino group, a carbonyl group, a carboxylic acid group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_{30}$-$C_{20}$ cycloalkyl group, a $C_3$-$C_{20}$ cycloalkoxy group, a $C_3$-$C_{20}$ cycloalkylthio group, a $C_6$-$C_{20}$ aryl group, or any combination thereof.

**6.** The organometallic compound of any of claims 1-5, wherein *-$R_{11}$-$(X_{11})_{n11}$ is represented by any one of Formulas 2-1 to 2-18 below,

*-$R_{12}$-$(X_{12})_{n12}$ is represented by any one of Formulas 2-21 to 2-38 below,
*-$R_{13}$-$(X_{13})_{n13}$ is represented by any one of Formulas 2-41 to 2-58 below, and
*-$R_{14}$-$(X_{14})_{n14}$ is represented by any one of Formulas 2-61 to 2-78 below:

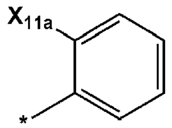
2-1

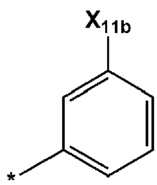
2-2

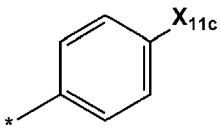
2-3

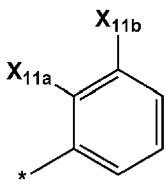
2-4

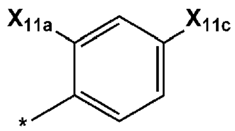
2-5

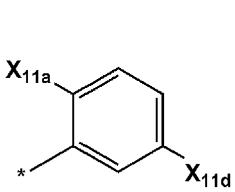
2-6

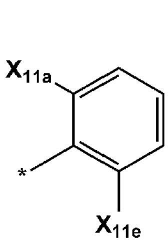
2-7

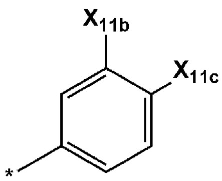
2-8

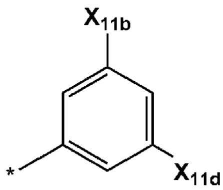
2-9

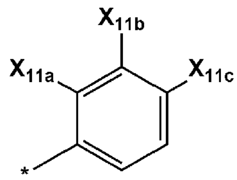
2-10

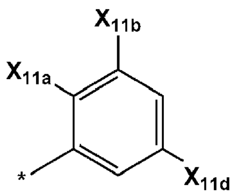 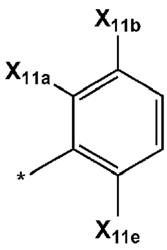 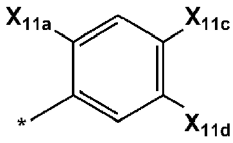 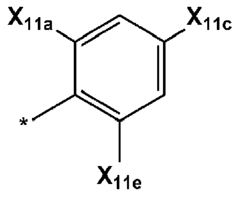 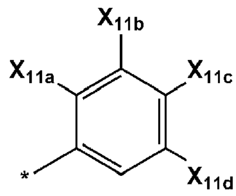

2-11 2-12 2-13 2-14 2-15

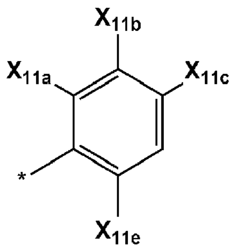 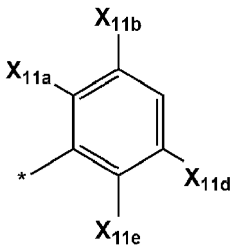 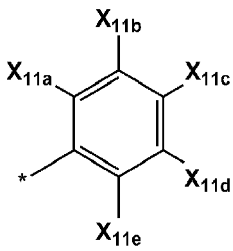

2-16 2-17 2-18

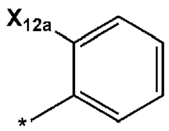 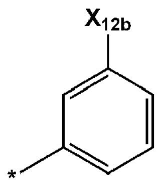 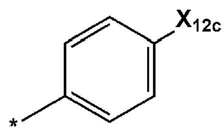 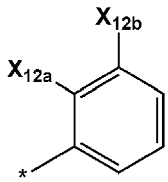 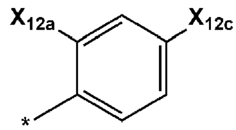

2-21 2-22 2-23 2-24 2-25

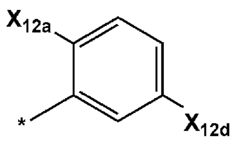 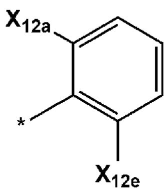 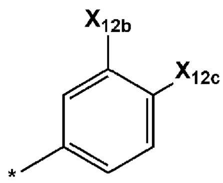 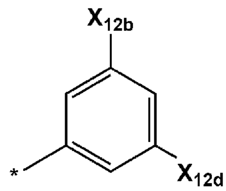 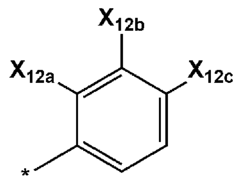

2-26 2-27 2-28 2-29 2-30

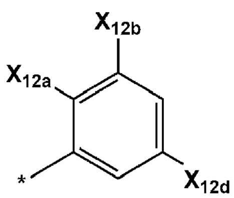 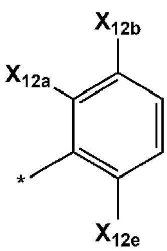 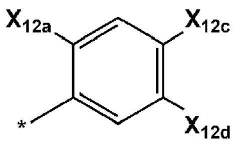 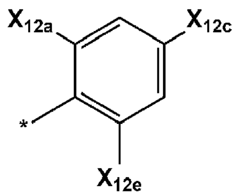 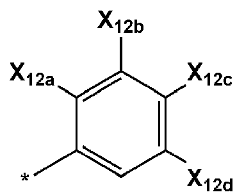

2-31 2-32 2-33 2-34 2-35

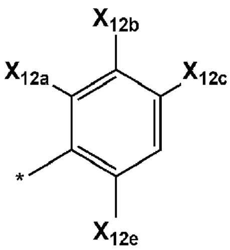
2-36

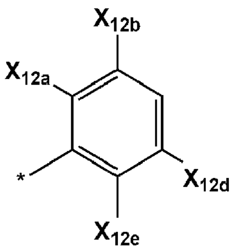
2-37

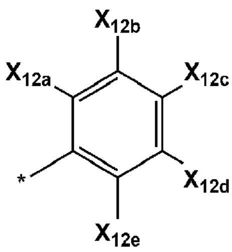
2-38

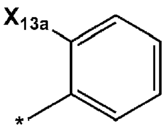
2-41

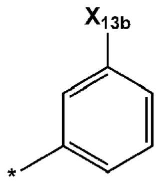
2-42

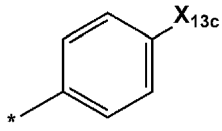
2-43

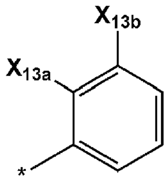
2-44

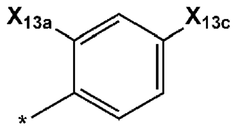
2-45

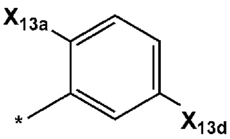
2-46

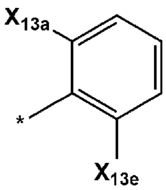
2-47

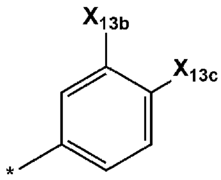
2-48

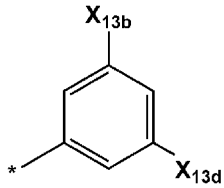
2-49

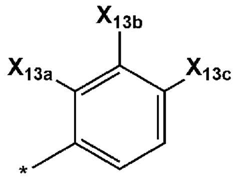
2-50

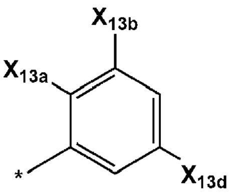
2-51

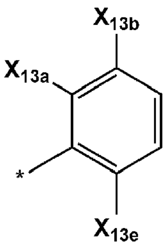
2-52

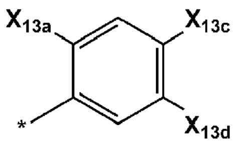
2-53

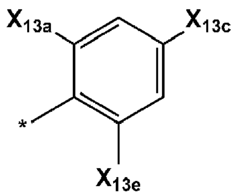
2-54

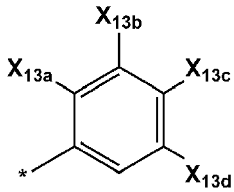
2-55

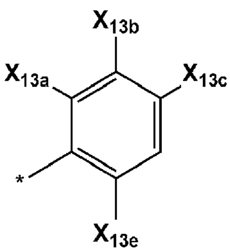
2-56

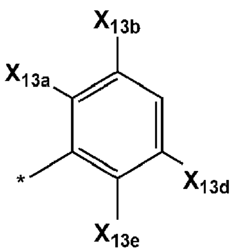
2-57

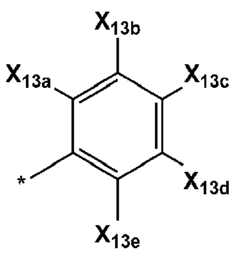
2-58

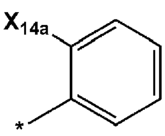
2-61

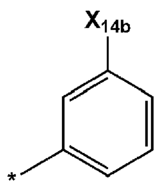
2-62

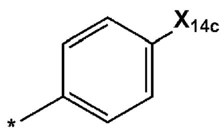
2-63

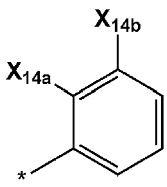
2-64

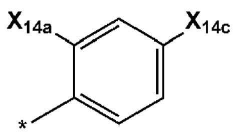
2-65

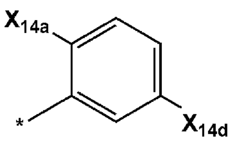
2-66

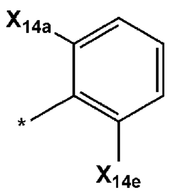
2-67

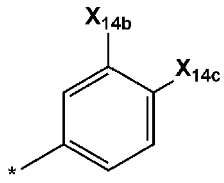
2-68

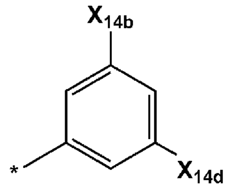
2-69

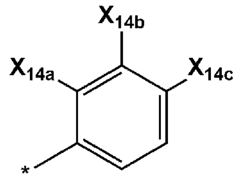
2-70

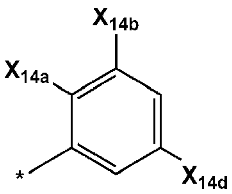
2-71

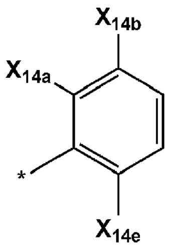
2-72

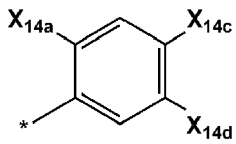
2-73

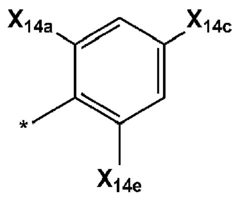
2-74

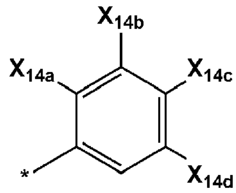
2-75

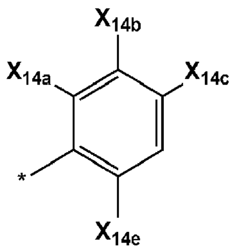
2-76

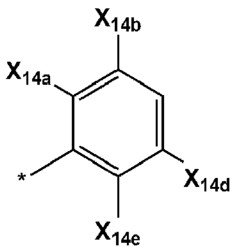
2-77

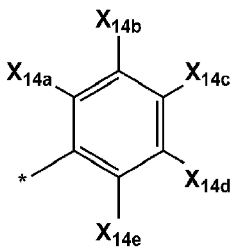
2-78

wherein, in Formulas 2-1 to 2-18, 2-21 to 2-38, 2-41 to 2-58, and 2-61 to 2-78,

$X_{11a}$ to $X_{11e}$, $X_{12a}$ to $X_{12e}$, $X_{13a}$ to $X_{13e}$, and $X_{14a}$ to $X_{14e}$ are each independently a halogen, a hydroxyl group, a cyano group, a nitro group, a carboxylic acid group, a linear, branched, or cyclic $C_1$-$C_{30}$ monovalent hydrocarbon group that optionally contains a heteroatom, or -N($Q_1$)($Q_2$), and

$Q_1$ and $Q_2$ are each independently hydrogen, deuterium, or a linear, branched, or cyclic monovalent $C_1$-$C_{30}$ hydrocarbon group that optionally contains a heteroatom;

preferably wherein

*-$R_{11}$-$(X_{11})_{n11}$ is represented by any one of Formulas 2-1, 2-3, 2-5, and 2-14,
*-$R_{12}$-$(X_{12})_{n12}$ is represented by any one of Formulas 2-21, 2-23, 2-25, and 2-34,
*-$R_{13}$-$(X_{13})_{n13}$ is represented by any one of Formulas 2-41, 2-43, 2-45, and 2-54,
*-$R_{14}$-$(X_{14})_{n14}$ is represented by any one of Formulas 2-61, 2-63, 2-65, and 2-74, or
*-$R_{11}$-$(X_{11})_{n11}$ is represented by any one of Formulas 2-2 and 2-9,
*-$R_{12}$-$(X_{12})_{n12}$ is represented by any one of Formulas 2-22 and 2-29,
*-$R_{13}$-$(X_{13})_{n13}$ is represented by any one of Formulas 2-42 and 2-49, and
*-$R_{14}$-$(X_{14})_{n14}$ is represented by any one of Formulas 2-62 and 2-69.

**7.** The organometallic compound of any of claims 1-6,

wherein n15 is 1 or 2,
in Formula 1-1, a sum of n11 and n12 is 1 or 2,
in Formula 1-2, a sum of n11, n12 and n13 is 1, 2, or 3,
in Formula 1-3, a sum of n11, n12, n13 and n14 is 1, 2, 3 or 4.

**8.** The organometallic compound of any of claims 1-7,
wherein $Y_{11}$ to $Y_{13}$ are each independently O or S.

**9.** The organometallic compound of any of claims 1-8, wherein

$R_{15}$ to $R_{17}$ are each independently represented by *-$(L_{15})_{a15}$-$X_{15}$,
$L_{15}$ is $CR_aR_b$, C=O, S=O, $SO_2$, $PO_2$, or $PO_3$,
a15 is an integer of 1 to 3,
$X_{15}$ is a linear, branched, or cyclic monovalent $C_1$-$C_{30}$ hydrocarbon group that optionally contains a heteroatom,
$R_a$ and $R_b$ are each independently hydrogen, deuterium, a halogen, a hydroxyl group, a cyano group, a nitro group, a substituted or unsubstituted $C_1$-$C_{30}$ alkyl group, a substituted or unsubstituted $C_1$-$C_{30}$ alkoxy group, a substituted or unsubstituted $C_3$-$C_{30}$ cycloalkyl group, a substituted or unsubstituted $C_3$-$C_{30}$ cycloalkoxy group, a substituted or unsubstituted $C_2$-$C_{30}$ alkenyl group, a substituted or unsubstituted $C_3$-$C_{30}$ cycloalkenyl group, a substituted or unsubstituted $C_2$-$C_{30}$ alkynyl group, a substituted or unsubstituted $C_6$-$C_{30}$ aryl group, or a substituted or unsubstituted $C_7$-$C_{30}$ arylakyl group, and
* is a bonding site to a neighboring atom.

**10.** The organometallic compound of any of claims 1-9,
wherein the organometallic compound represented by Formulas 1-1 to 1-4 is selected from a structure in group I below:
<Group I>

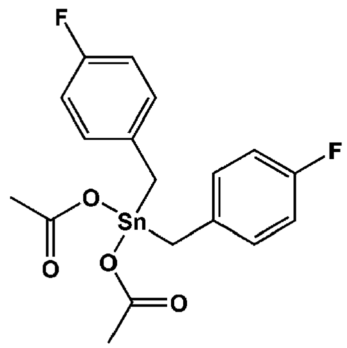

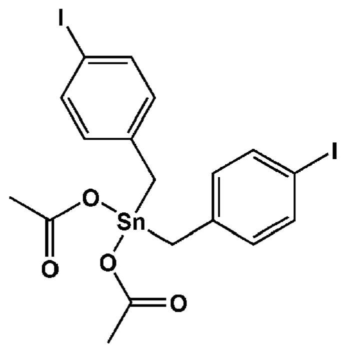

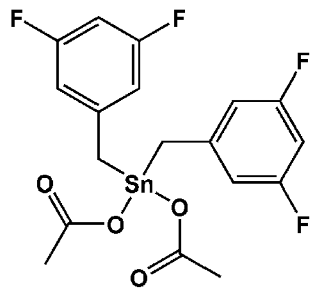

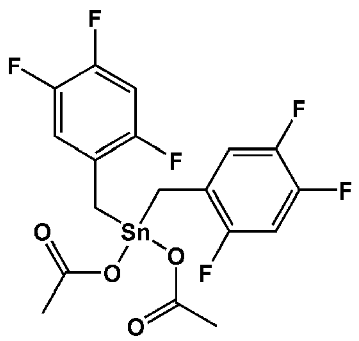

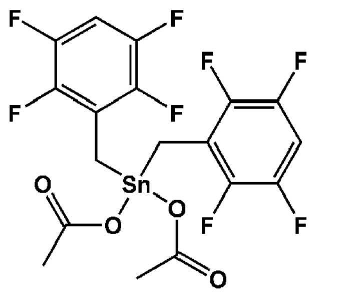

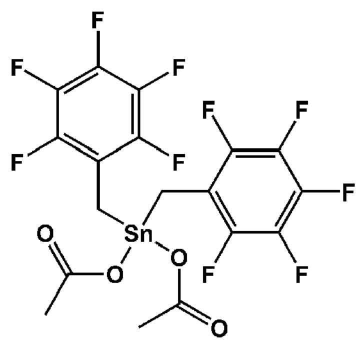

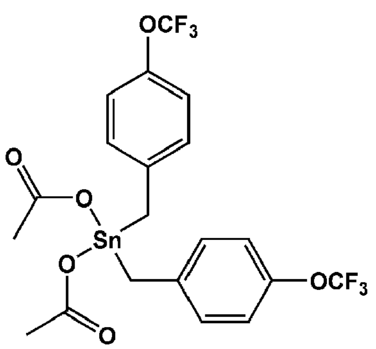

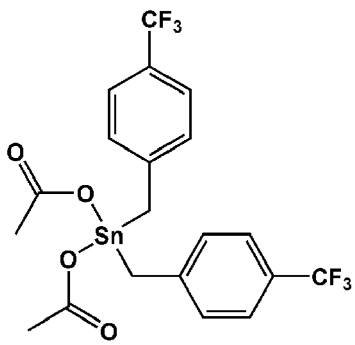

**11.** A resist composition comprising:

The organometallic compound of any of claims 1-10.

**12.** The resist composition of claim 11, wherein the resist composition substantially does not comprise a photoacid generator; and/or
wherein the resist composition substantially does not comprise a compound having a molecular weight of 1000 or more.

**13.** The resist composition of claims 11 or 12, further comprising an organic solvent;
preferably wherein the organic solvent includes an aprotic organic solvent.

**14.** A pattern forming method comprising:

Forming a resist film by applying the resist composition of any of claims 11-13;
exposing at least a portion of the resist film to high-energy rays; and
developing the exposed resist film by using a developing solution.

**15.** The pattern forming method of claim 14, wherein the exposing is performed by irradiating at least one of ultraviolet rays, deep ultraviolet rays (DUV), extreme ultraviolet rays (EUV), X-rays, $\gamma$-rays, electron beams (EB) and/or a-particles to the resist film; and/or

wherein a chemical bond is formed between the organometallic compounds by the exposing at least a portion of the resist film to high-energy rays; and/or
wherein the exposed resist film includes an exposed portion and an unexposed portion, and the unexposed portion is removed in the developing.

FIG. 1

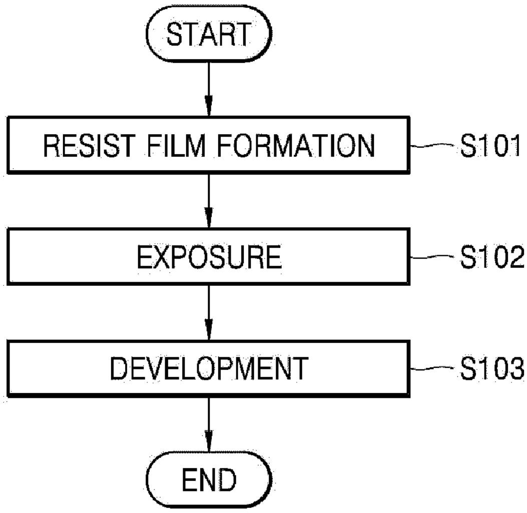
START
RESIST FILM FORMATION
S101
EXPOSURE
S102
DEVELOPMENT
S103
END

FIG. 2A

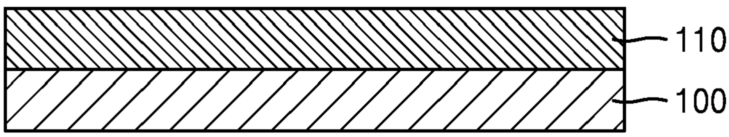

FIG. 2B

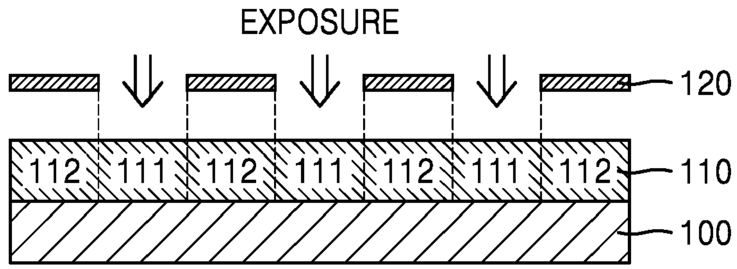

FIG. 2C

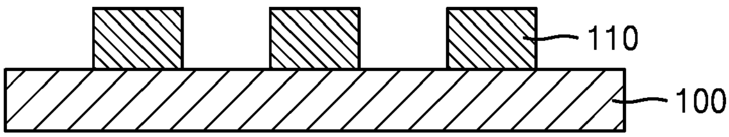

FIG. 3A

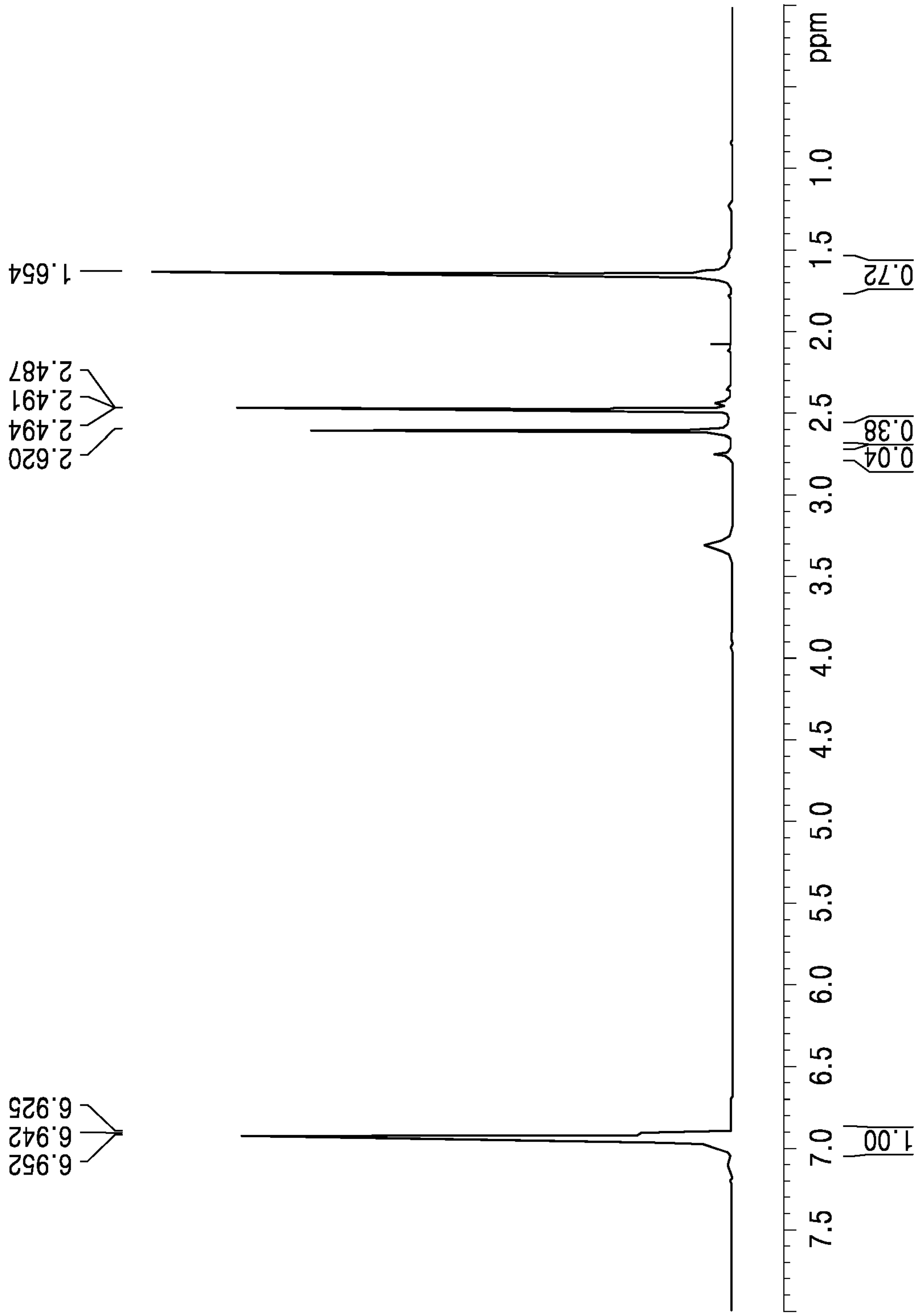

1.654
2.487
2.491
2.494
2.620
6.925
6.942
6.952
ppm
1.0
1.5
2.0
2.5
3.0
3.5
4.0
4.5
5.0
5.5
6.0
6.5
7.0
7.5
0.72
0.38
0.04
1.00

FIG. 3B

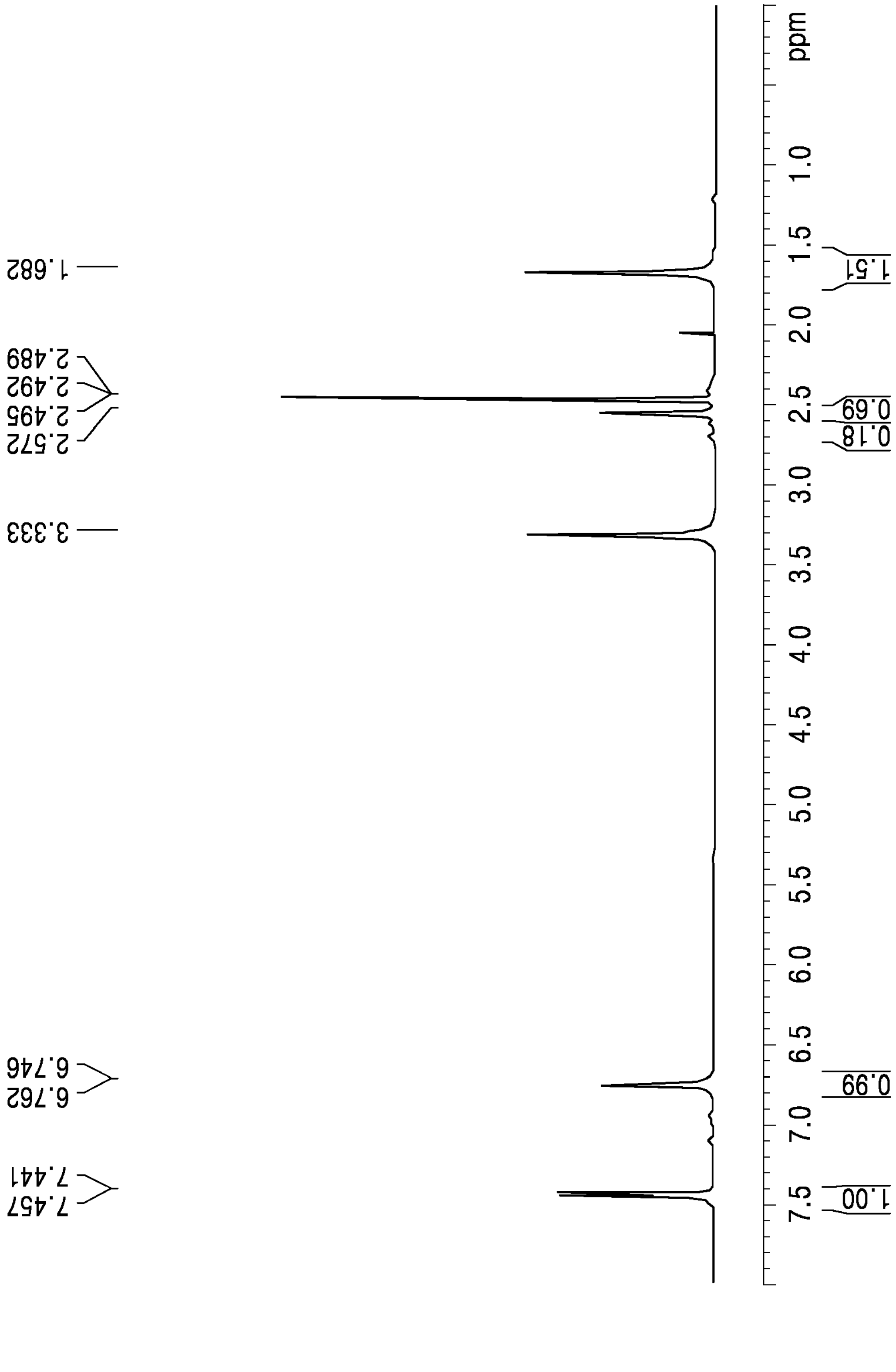

1.682
2.489
2.492
2.495
2.572
3.333
6.746
6.762
7.441
7.457
ppm
1.0
1.5
2.0
2.5
3.0
3.5
4.0
4.5
5.0
5.5
6.0
6.5
7.0
7.5
1.51
0.69
0.18
0.99
1.00

FIG. 3C

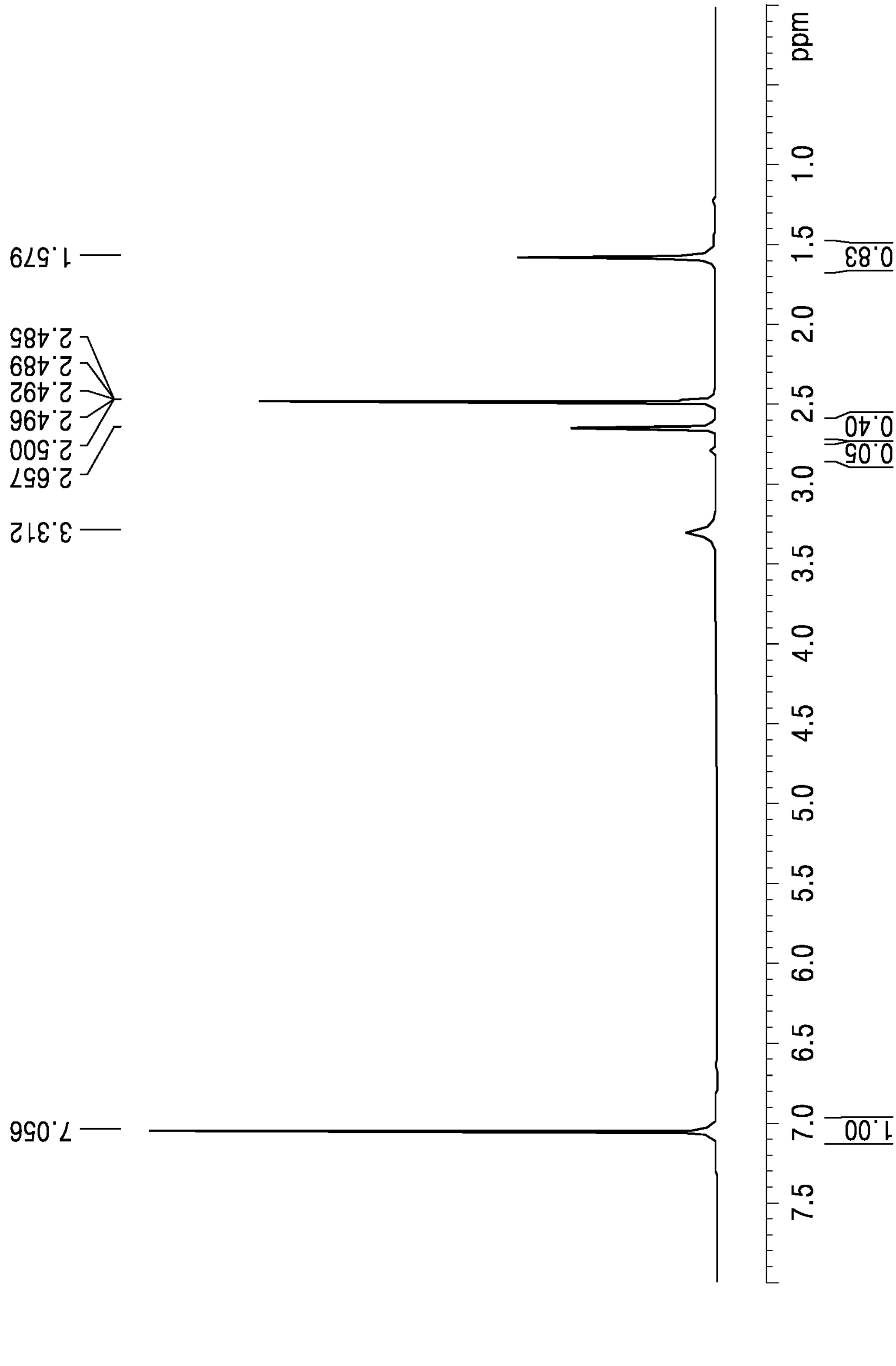
1.579
2.485
2.489
2.492
2.496
2.500
2.657
3.312
7.056
ppm
1.0
1.5
2.0
2.5
3.0
3.5
4.0
4.5
5.0
5.5
6.0
6.5
7.0
7.5
0.83
0.40
0.05
1.00

FIG. 4A

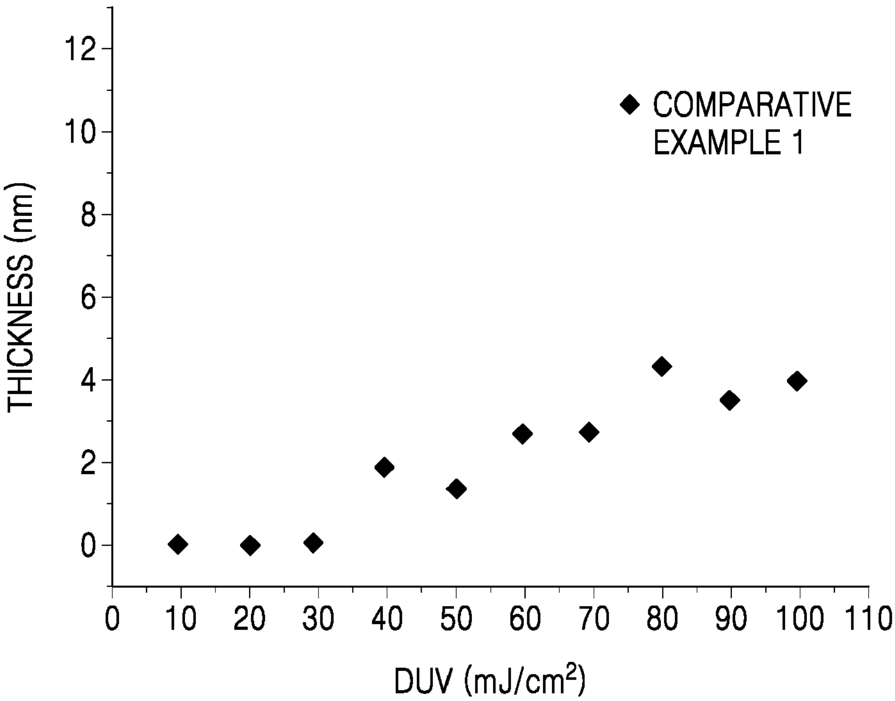
12
10
8
6
4
2
0
THICKNESS (nm)
COMPARATIVE EXAMPLE 1
0 10 20 30 40 50 60 70 80 90 100 110
DUV (mJ/cm2)

FIG. 4B

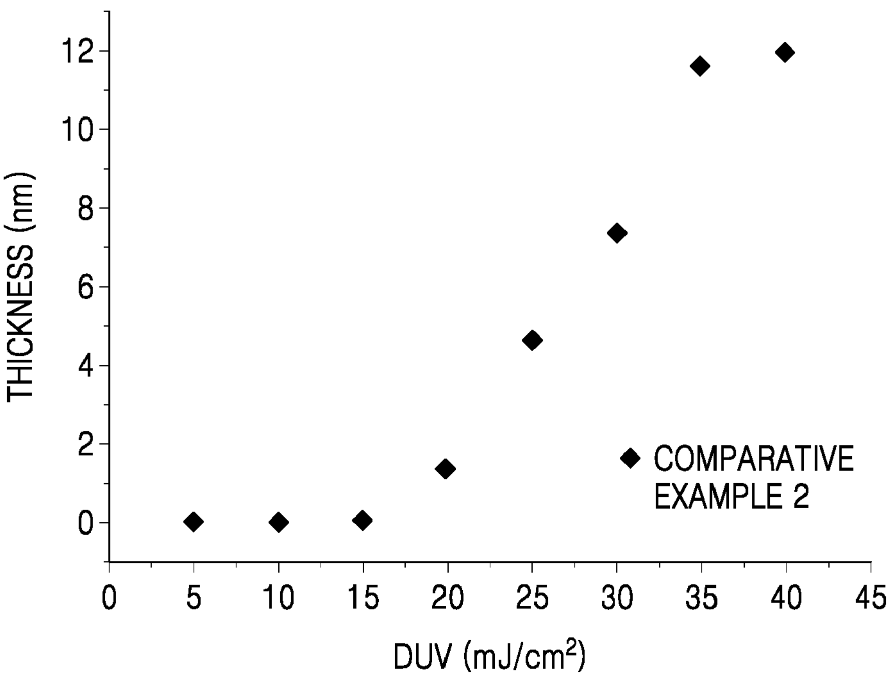
THICKNESS (nm)
12
10
8
6
4
2
0
0
5
10
15
20
25
30
35
40
45
DUV (mJ/cm2)
COMPARATIVE EXAMPLE 2

FIG. 4C

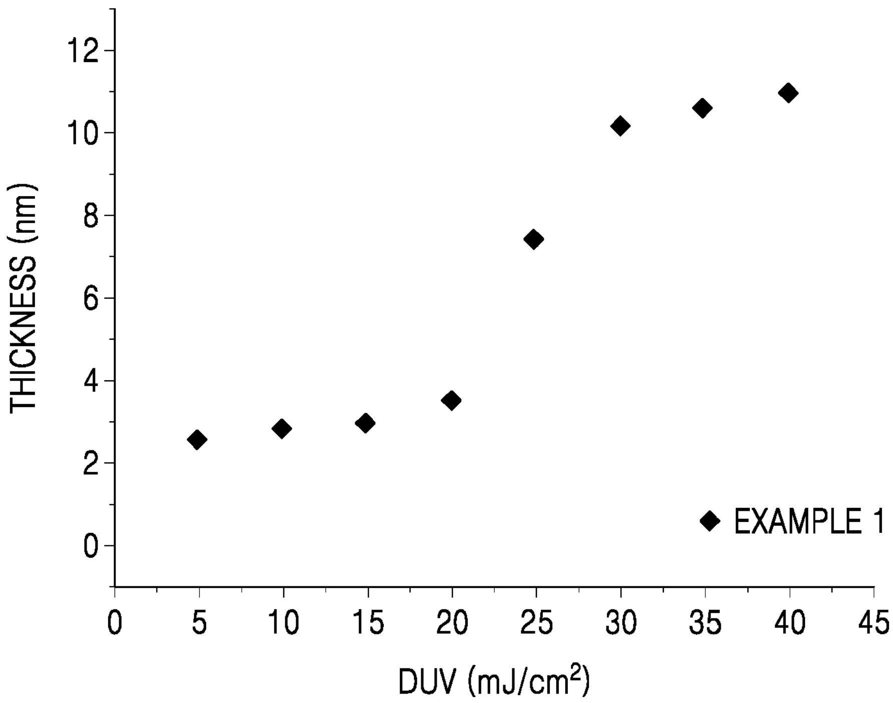
12
10
8
6
4
2
0
THICKNESS (nm)
EXAMPLE 1
0
5
10
15
20
25
30
35
40
45
DUV (mJ/cm2)

FIG. 4D

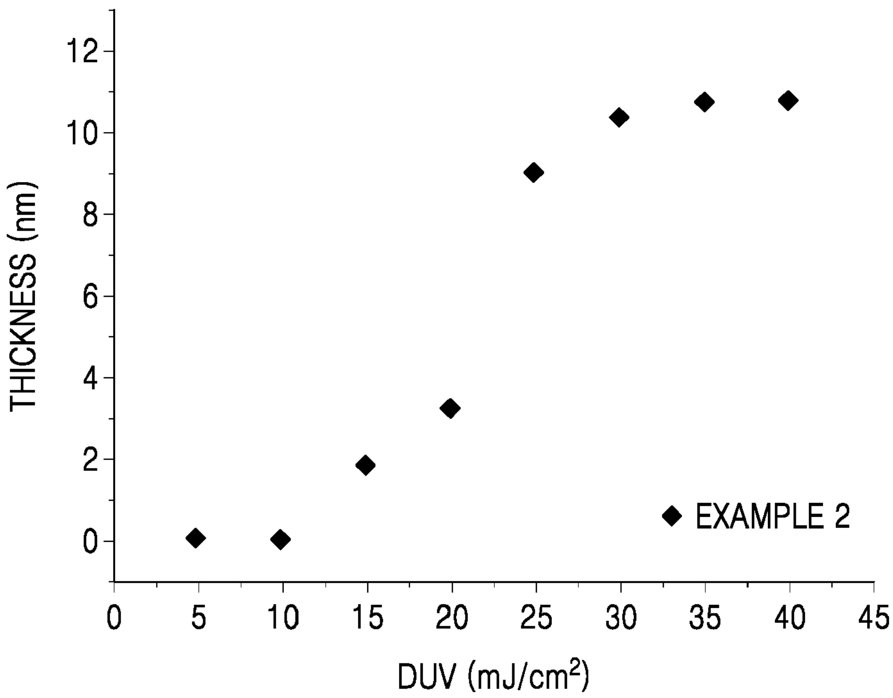
THICKNESS (nm)
12
10
8
6
4
2
0
0
5
10
15
20
25
30
35
40
45
DUV (mJ/cm2)
EXAMPLE 2

FIG. 4E

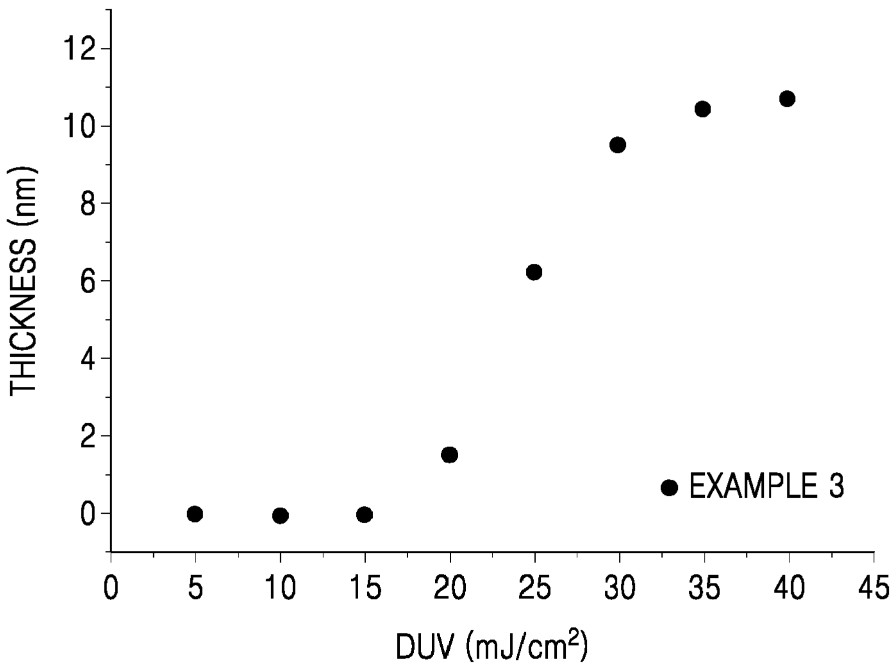
THICKNESS (nm)
12
10
8
6
4
2
0
0
5
10
15
20
25
30
35
40
45
DUV (mJ/cm²)
EXAMPLE 3

FIG. 5A

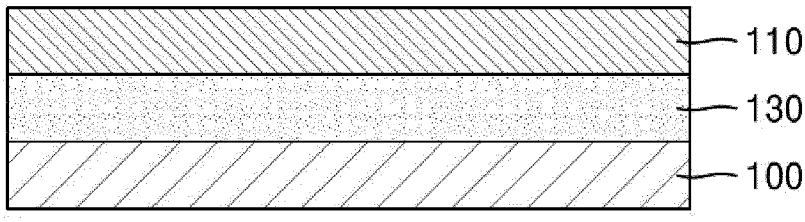

FIG. 5B

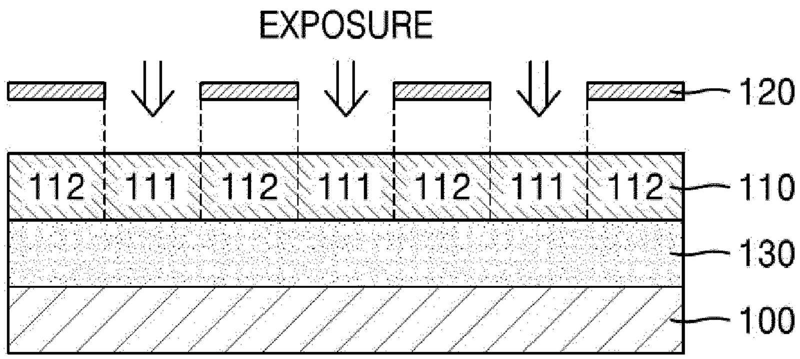

FIG. 5C

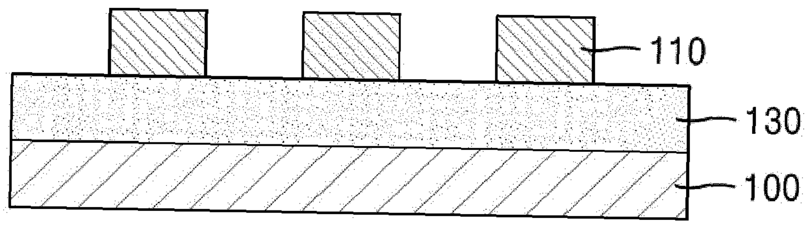

FIG. 5D

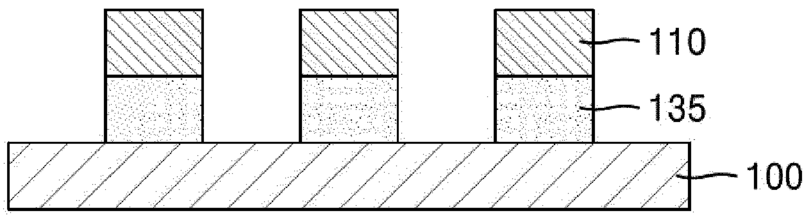

FIG. 5E

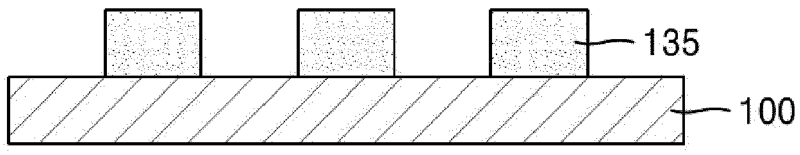

Europäisches Patentamt
European Patent Office
Office européen des brevets

# EUROPEAN SEARCH REPORT

Application Number
EP 23 18 0869

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DATABASE REAXYS [Online]<br><br>1 January 2019 (2019-01-01), Mitsubishi Gas Chemical Company Inc: "COMPOSITION FOR RESIST UNDERLAYER FILM FORMATION, UNDERLAYER FILM FOR LITHOGRAPHY, AND PATTERN FORMATION METHOD - EP3451059 A1", XP093100985, Database accession no. XRN = 36512796, XRN = 36512799<br>* abstract *<br>-& EP 3 451 059 A1 (MITSUBISHI GAS CHEMICAL CO [JP])<br>6 March 2019 (2019-03-06)<br>* page 38 *<br>* page 39 *<br>* claims 1-34 *<br>* abstract *<br>----- | 1-15 | INV.<br>C07F7/22<br>G03F7/00 |
| X | KR 2021 0128796 A (SAMSUNG SDI CO LTD [KR]) 27 October 2021 (2021-10-27)<br>* paragraph [0162] - paragraph [0163] *<br>* abstract *<br>----- | 1-15 | TECHNICAL FIELDS SEARCHED (IPC)<br>C07F<br>G03F |
| X | CN 110 204 570 A (UNIV HENGYANG NORMAL)<br>6 September 2019 (2019-09-06)<br>* paragraph [0036] *<br>-----<br>-/-- | 1-9,11 | |

The present search report has been drawn up for all claims

3

| Place of search | Date of completion of the search | Examiner |
|---|---|---|
| The Hague | 22 March 2024 | Eberhard, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 23 18 0869

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DAMUDE LESLIE C. ET AL: "Synthesis and multinuclear magnetic resonance study of some tin(IV) complexes of pyridine-2-thiolate and related ligands, and the X-ray structural analysis of Sn(C 5 H 4 NS) 4 -C 5 H 5 NS", CANADIAN JOURNAL OF CHEMISTRY, vol. 68, no. 8, 1 August 1990 (1990-08-01), pages 1323-1331, XP093100986, CA ISSN: 0008-4042, DOI: 10.1139/v90-204 * tables 4 entries 7-10 * ----- | 1-8,11 | |
| X | C. PANT BHUVAN: "Synthesis of organotellurium acetates", TETRAHEDRON LETTERS, vol. 13, no. 47, 1 January 1972 (1972-01-01), pages 4779-4780, XP093100987, Amsterdam , NL ISSN: 0040-4039, DOI: 10.1016/S0040-4039(01)94425-9 * first equation * ----- | 1,3-9,11 | TECHNICAL FIELDS SEARCHED (IPC) |
| E | WO 2023/158848 A2 (UNIV NEW YORK STATE RES FOUND [US]) 24 August 2023 (2023-08-24) * the whole document * ----- | 1-15 | |
| A | US 2022/252976 A1 (SONG HYUN-JI [KR] ET AL) 11 August 2022 (2022-08-11) * paragraph [0026] * ----- | 1-15 | |
| X | CN 108 864 174 B (UNIV HENGYANG NORMAL) 11 December 2020 (2020-12-11) * claim 1 * ----- | 1-9 | |
| | -/-- | | |

The present search report has been drawn up for all claims

| Place of search | Date of completion of the search | Examiner |
|---|---|---|
| The Hague | 22 March 2024 | Eberhard, Michael |

3

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 23 18 0869

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 109 134 528 A (UNIV HENGYANG NORMAL) 4 January 2019 (2019-01-04)<br>* claim 1 *<br>----- | 1-9 | |
| X | DATABASE REAXYS [Online]<br><br>1 January 2021 (2021-01-01),<br>Ku Y: "Highly fluorinated alternating copolymers possessing high glass transition temperature and cross-linking capabilities under extreme UV radiation",<br>XP093143817,<br>Database accession no. XRN = 3819297<br>* abstract *<br>& KU YE-JIN ET AL: "Highly fluorinated alternating copolymers possessing high glass transition temperature and cross-linking capabilities under extreme UV radiation",<br>PROCEEDINGS OF THE SPIE, SPIE, US,<br>vol. 11612, 22 February 2021 (2021-02-22), pages 116120J-116120J, XP060139064,<br>ISSN: 0277-786X, DOI: 10.1117/12.2582948<br>ISBN: 978-1-5106-5738-0<br>----- | 1-4,8,9, 11-15 | |
| X | EP 3 667 419 A1 (JSR CORP [JP]) 17 June 2020 (2020-06-17)<br>* example 4 *<br>* paragraph [0115] *<br>* abstract *<br>* table 1 *<br>----- | 1-7, 11-15 | TECHNICAL FIELDS SEARCHED (IPC) |
| X<br><br>A | US 2020/041896 A1 (MOON KYUNG SOO [KR] ET AL) 6 February 2020 (2020-02-06)<br>* compounds Chemical Formulae 5-12 *<br>* abstract *<br>----- | 1-4,8,9, 11-15<br>5-7 | |

3

The present search report has been drawn up for all claims

| Place of search | Date of completion of the search | Examiner |
|---|---|---|
| The Hague | 22 March 2024 | Eberhard, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

Application Number
EP 23 18 0869

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches Patentamt
European Patent Office
Office européen des brevets

# LACK OF UNITY OF INVENTION SHEET B

Application Number
EP 23 18 0869

The Search Division considers that the present European patent application does not comply with the requirements of unity of invention and relates to several inventions or groups of inventions, namely:

**1. claims: 10(completely); 1-9, 11-15(partially)**

An organometallic compound represented by Formula 1-1; a resist composition comprising such a compound; and a pattern forming method comprising using such a composition.

---

**2. claims: 1-9, 11-15(all partially)**

An organometallic compound represented by Formula 1-2; a resist composition comprising such a compound; and a pattern forming method comprising using such a composition.

---

**3. claims: 1-7, 11-15(all partially)**

An organometallic compound represented by Formula 1-3; a resist composition comprising such a compound; and a pattern forming method comprising using such a composition.

---

**4. claims: 1-9, 11-15(all partially)**

An organometallic compound represented by Formula 1-4; a resist composition comprising such a compound; and a pattern forming method comprising using such a composition.

---

## ANNEX TO THE EUROPEAN SEARCH REPORT ON EUROPEAN PATENT APPLICATION NO. EP 23 18 0869

This annex lists the patent family members relating to the patent documents cited in the above-mentioned European search report. The members are as contained in the European Patent Office EDP file on
The European Patent Office is in no way liable for these particulars which are merely given for the purpose of information.

22-03-2024

| Patent document cited in search report | | Publication date | Patent family member(s) | | | Publication date |
|---|---|---|---|---|---|---|
| EP 3451059 | A1 | 06-03-2019 | CN | 109154777 | A | 04-01-2019 |
| | | | EP | 3451059 | A1 | 06-03-2019 |
| | | | JP | 7116891 | B2 | 12-08-2022 |
| | | | JP | WO2017188451 | A1 | 28-02-2019 |
| | | | KR | 20190003528 | A | 09-01-2019 |
| | | | TW | 201811876 | A | 01-04-2018 |
| | | | US | 2020249573 | A1 | 06-08-2020 |
| | | | WO | 2017188451 | A1 | 02-11-2017 |
| KR 20210128796 | A | 27-10-2021 | NONE | | | |
| CN 110204570 | A | 06-09-2019 | NONE | | | |
| WO 2023158848 | A2 | 24-08-2023 | NONE | | | |
| US 2022252976 | A1 | 11-08-2022 | KR | 20220115398 | A | 17-08-2022 |
| | | | US | 2022252976 | A1 | 11-08-2022 |
| CN 108864174 | B | 11-12-2020 | NONE | | | |
| CN 109134528 | A | 04-01-2019 | NONE | | | |
| EP 3667419 | A1 | 17-06-2020 | EP | 3667419 | A1 | 17-06-2020 |
| | | | JP | WO2019031250 | A1 | 02-07-2020 |
| | | | KR | 20200039665 | A | 16-04-2020 |
| | | | TW | 201910391 | A | 16-03-2019 |
| | | | US | 2020166840 | A1 | 28-05-2020 |
| | | | WO | 2019031250 | A1 | 14-02-2019 |
| US 2020041896 | A1 | 06-02-2020 | KR | 20200014043 | A | 10-02-2020 |
| | | | US | 2020041896 | A1 | 06-02-2020 |

EPO FORM P0459

For more details about this annex : see Official Journal of the European Patent Office, No. 12/82